# EUROPÄISCHE PATENTANMELDUNG

(11) **EP 3 236 498 A1**
(43) Veröffentlichungstag der Anmeldung: **25.10.2017**
(21) Anmeldenummer: 17166528.4
(22) Anmeldetag: 13.04.2017
(51) Int. Cl.: H01L 25/07, H01L 23/00, H01L 25/18, H02M 7/00, H01L 23/48, H01L 23/495, H01L 25/16

(54) **LEISTUNGSHALBLEITERBAUTEIL MIT ZWEI LATERALEN LEISTUNGSHALBLEITERBAUELEMENTEN IN HALBBRÜCKENSCHALTUNG**

(30) Priorität: 18.04.2016 DE 102016206501
(71) Anmelder: Fraunhofer-Gesellschaft zur Förderung der angewandten Forschung e.V., 80686 München (DE)
(72) Erfinder: HOENE, Eckart, 13465 Berlin (DE); KLEIN, Kirill, 10785 Berlin (DE)
(74) Vertreter: Schenk, Markus

(57) **Zusammenfassung**

Leistungshalbleiterbauteil umfassend:
ein erstes laterales Leistungshalbleiterbauelement;
ein zweites laterales Leistungshalbleiterbauelement;
eine Trägeranordnung, welche ein Trägersubstrat aufweist, welches eine leitende Schicht mit einer nach außen weisenden Fläche umfasst;
ein erster an der Trägeranordnung angeordneter Kontakt zum Anschließen eines ersten Potentials einer Außenspannung an eine externe Schaltung; und
ein zweiter an der Trägeranordnung angeordneter Kontakt zum Anschließen eines zweiten Potentials der Außenspannung an die externe Schaltung;
wobei das erste Leistungshalbleiterbauelement und das zweite Leistungshalbleiterelement an der nach außen weisenden Fläche in einer lateralen Richtung versetzt angeordnet sind;
wobei der erste Kontakt an einem ersten endseitigen Abschnitt der leitenden Schicht mittels einer ersten elektrischen Verbindung an die leitende Schicht angeschlossen ist;
wobei ein erster Nutzstromkontakt des zweiten Leistungshalbleiterbauelements an einem zweiten endseitigen Abschnitt der leitenden Schicht mittels einer zweiten elektrischen Verbindung an die leitende Schicht angeschlossen ist.

## Beschreibung

Leistungshalbleiteranordnungen in Halbbrückenschaltung sind aus dem Stand der Technik bekannt. So offenbart beispielsweise die Druckschrift US 2014/0183550A1 eine Leistungshalbleiteranordnung, welche zwei diskrete Leistungshalbleiterbauelemente umfasst. Die beiden Feldeffekttransistoren sind jeweils unabhängig voneinander an einer Leiterplatte angeordnet und mittels der Leiterplatte zu einer Halbbrücke verschaltet.

Aus der Praxis ist eine Leistungshalbleiteranordnung bekannt, welches mindestens zwei laterale Leistungshalbleiterbauelemente umfasst, welche in einen gemeinsamen Rahmen eingebaut sind, so dass sie ein integriertes Leistungshalbleiterbauteil bilden. Eine derartige Leistungshalbleiteranordnung wird oft als Modul bezeichnet.

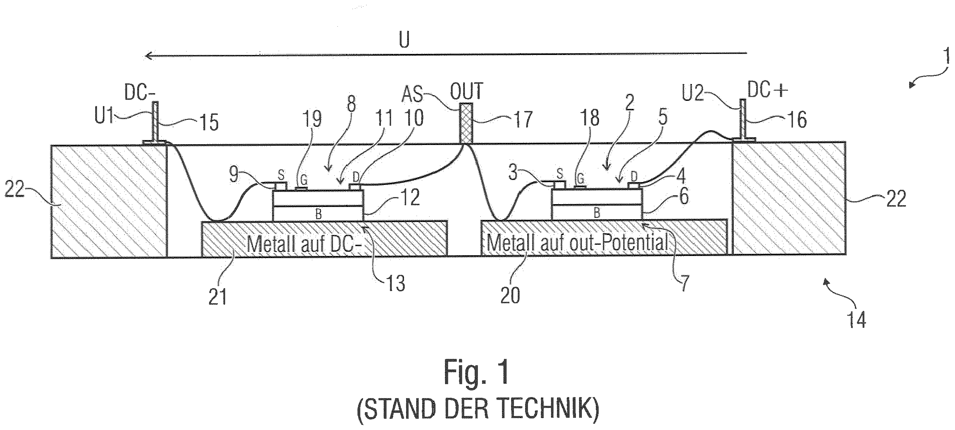

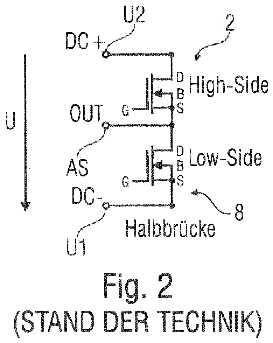

Bei jedem der beiden Leistungshalbleiterbauelemente liegt ein Potenzial des jeweiligen elektrisch leitenden Halbleitersubstrats auf dem Potenzial eines Source-Kontaktes des jeweiligen Leistungshalbleiterbauelements. Dabei ist das Halbleitersubstrat des ersten Leistungshalbleiterbauelements auf einem ersten Metallträger und das Halbleitersubstrat des zweiten Leistungshalbleiterbauelements auf einem zweiten Metallträger angeordnet, wobei die beiden Metallträger elektrisch voneinander isoliert sind. Die aus der Praxis vorbekannte Leistungshalbleiteranordnung ist weiter unten anhand der Fig. 1 und 2 näher beschrieben.

Aufgabe der vorliegenden Erfindung ist es, ein verbessertes Leistungshalbleiterbauteil mit zwei lateralen Leistungshalbleiterbauelementen in Halbbrückenschaltung zu schaffen.

Die Aufgabe wird gelöst durch ein Leistungshalbleiterbauteil umfassend:
ein erstes laterales Leistungshalbleiterbauelement, welches einen ersten Nutzstromkontakt und einen zweiten Nutzstromkontakt aufweist, welche beide an einer ersten Seite des ersten Leistungshalbleiterbauelements angeordnet sind, wobei das erste Leistungshalbleiterbauelement ein Halbleitersubstrat aufweist, welches sich entlang einer der ersten Seite gegenüberliegenden zweiten Seite des ersten Leistungshalbleiterbauelements erstreckt;
ein zweites laterales Leistungshalbleiterbauelement, welches einen ersten Nutzstromkontakt und einen zweiten Nutzstromkontakt aufweist, welche beide an einer ersten Seite des zweiten Leistungshalbleiterbauelements angeordnet sind, wobei das zweite Leistungshalbleiterbauelement ein Halbleitersubstrat aufweist, welches sich entlang einer der ersten Seite gegenüberliegenden zweiten Seite des zweiten Leistungshalbleiterbauelements erstreckt;
eine Trägeranordnung, welche ein Trägersubstrat aufweist, welches eine leitende Schicht mit einer nach außen weisenden Fläche umfasst;
ein erster an der Trägeranordnung angeordneter Kontakt zum Anschließen eines ersten Potentials einer Außenspannung an eine externe Schaltung; und
ein zweiter an der Trägeranordnung angeordneter Kontakt zum Anschließen eines zweiten Potentials der Außenspannung an die externe Schaltung;
wobei die besagten Leistungshalbleiterbauelemente als Halbbrücke verschaltet sind;
wobei wenigstens eines der besagten Leistungshalbleiterbauelemente als schaltbares Leistungshalbleiterbauelement ausgebildet ist, welches einen Steuerkontakt aufweist, welcher an der ersten Seite des jeweiligen Leistungshalbleiterbauelements angeordnet ist;
wobei das erste Leistungshalbleiterbauelement und das zweite Leistungshalbleiterelement mit ihrer jeweiligen zweiten Seite an der nach außen weisenden Fläche der leitenden Schicht des Trägersubstrates in einer lateralen Richtung angeordnet sind;
wobei das erste Leistungshalbleiterbauelement an einem in der lateralen Richtung gesehen ersten endseitigen Abschnitt der leitenden Schicht angeordnet ist, und das zweite Leistungshalbleiterbauelement an einem dem ersten endseitigen Abschnitt in der lateralen Richtung gesehen gegenüberliegenden zweiten endseitigen Abschnitt der leitenden Schicht angeordnet ist; wobei der erste Kontakt an dem ersten endseitigen Abschnitt der leitenden Schicht mittels einer ersten elektrischen Verbindung an die leitende Schicht angeschlossen ist;
wobei der erste Nutzstromkontakt des zweiten Leistungshalbleiterbauelements an dem zweiten endseitigen Abschnitt der leitenden Schicht mittels einer zweiten elektrischen Verbindung an die leitende Schicht angeschlossen ist.

Bei dem schaltbaren lateralen Leistungshalbleiterbauelement kann es sich um einen Transistor, insbesondere um einen Feldeffekttransistor (FET) handeln. Bevorzugt kann ein Sperrschicht-Feldeffekt-Transistor (JFET), ein Schottky-Feldeffekt-Transistor (MESFET), ein Metalloxidhalbleiter-Feldeffekt-Transistor (MOSFET), ein High Electron Mobility Transistor (HEMT), ein lonen-Sensitiver Feldeffekt-Transistor (ISFET), ein Organischer Feldeffekttransistor (OFET) oder ein Insulated Gate Bipolar Transistor (IGBT) verwendet werden.

Beispielsweise kann es sich um einen Galiumnitrid-Transistor (GaN-Transistor) mit einem Halbleitersubstrat aus Siliziumcarbid (SiC) oder Silizium (Si) handeln. Transistoren weisen mindestens drei Kontakte auf, nämlich zwei Nutzstromkontakte und einen Steuerkontakt. Bei einem bipolaren Transistor werden die Nutzstromkontakte als Kollektor und Emitter und der Steuerkontakt als Basis bezeichnet. Weiterhin werden bei einem Feldeffekttransistor die Nutzstromkontakte als Drain und Source und der Steuerkontakt als Gate bezeichnet.

Erfindungsgemäß sind das erste Leistungshalbleiterbauelement und das zweite Leistungshalbleiterelement jeweils als laterales Leistungshalbleiterelement ausgebildet. Diese zeichnen sich dadurch aus, dass alle Nutzstrom- und Steuerkontakte auf einer ersten Seite des jeweiligen Leistungshalbleiterbauelements angeordnet sind, wobei an der gegenüberliegenden zweiten Seite des jeweiligen Leistungshalbleiterbauelements ein Halbleitersubstrat angeordnet ist. Unter den Begriff "laterales Leistungshalbleiterbauelement" im Sinne der vorliegenden Erfindung fallen alle (auch die so genannten "quasi-vertikalen") Leistungshalbleiterbauelemente, bei denen alle Nutzstrom- und Steuerkontakte auf einer ersten Seite des jeweiligen Leistungshalbleiterbauelements angeordnet sind.

Dabei ist das Halbleitersubstrat leitend ausgebildet und mittels einer isolierenden Struktur von einem aktiven Bereich des Leistungshalbleiterbauelements elektrisch isoliert.

Das Halbleitersubstrat kann in anderen Ausführungsbeispielen aus einem nicht leitfähigen Material bestehen, bei dem es sich beispielsweise um nichtleitendes Siliziumcarbid handelt. Die isolierende Struktur kann in diesen Ausführungsbeispielen entfallen.

Aus Praxis ist eine monolithisch integrierte Ausführung der Halbbrückenschaltung bekannt. Bei dieser werden beide Leistungshalbleiterbauelemente auf einem gemeinsamen Substrat hergestellt. Der zweite Nutzstromkontakt des zweiten Leistungshalbleiters kann in diesem Fall zusammen mit dem ersten Nutzstromkontakt des ersten Leistungshalbleiters einen gemeinsamen Kontakt bilden. In diesem Fall bilden beide Transistoren zwar eine Einheit, sind jedoch dennoch lateral versetzt.

Da wenigstens eines der besagten Leistungshalbleiterbauelemente als schaltbares Leistungshalbleiterbauelement ausgebildet ist, kann die gebildete Halbbrücke auch als schaltbare Halbbrücke bezeichnet werden. In einem Ausführungsbeispiel sind beide der besagten Leistungshalbleiterbauelemente schaltbar ausgeführt. Es wäre jedoch auch möglich, das erste Leistungshalbleiterbauelement schaltbar und das zweite Leistungshalbleiterbauelement nicht schaltbar auszuführen. Ebenso wäre es möglich, das erste Leistungshalbleiterbauelement nicht schaltbar und das zweite Leistungshalbleiterbauelement schaltbar auszuführen.

Bei dem nicht schaltbaren lateralen Leistungshalbleiterbauelement, kann es sich insbesondere um eine Diode beliebiger Bauart handeln. Bei einer Diode werden üblicherweise die Nutzstromkontakte als Anode und Kathode bezeichnet. Ein Steuerkontakt ist bei einer Diode im Regelfall nicht vorgesehen.

Das erfindungsgemäße Leistungshalbleiterbauelement kann beispielsweise in einem Wechselrichter, in einem Gleichspannungswandler oder in einem Frequenzumrichter eingesetzt werden.

Der Steuerkontakt des ersten Leistungshalbleiterbauelements und der Steuerkontakt des zweiten Leistungshalbleiterbauelements können mit einem Treiber des Leistungshalbleiterbauteils oder mit einem externen Treiber verbunden sein, wobei der jeweilige Treiber zum Schalten des ersten und/oder des zweiten Leistungshalbleiterbauelements ausgebildet sein kann.

In einem Ausführungsbeispiel umfasst die Trägeranordnung einen Rahmen und die leitende Schicht, welche mechanisch miteinander verbunden sind.

Unter einem ersten endseitigen Abschnitt der leitenden Schicht kann dabei in einem weiteren Sinn ein Abschnitt verstanden werden, der sich in der lateralen Richtung gesehen von einem ersten Ende der leitenden Schicht bis zur Mitte der leitenden Schicht erstreckt. Analog kann unter einem zweiten endseitigen Abschnitt in einem weiteren Sinn ein Abschnitt verstanden werden, der sich in der lateralen Richtung gesehen von einem anderen Ende der leitenden Schicht bis zum Mitte der leitenden Schicht erstreckt. In einem engeren Sinn kann unter dem ersten endseitigen Abschnitt ein Abschnitt verstanden werden, der sich von dem ersten Ende der leitenden Schicht in der lateralen Richtung gesehen über ein Drittel der Gesamtlänge der leitenden Schicht erstreckt. Ebenso kann unter dem zweiten endseitigen Abschnitt ein Abschnitt verstanden werden, der sich von dem zweiten Ende der leitenden Schicht in der lateralen Richtung gesehen über ein Drittel der Gesamtlänge der leitenden Schicht erstreckt.

In einem Ausführungsbeispiel ist eine erste Polarität der Außenspannung vorgesehen, bei der das zweite Potenzial der Außenspannung höher ist als das erste Potenzial der Außenspannung. Bei der ersten Polarität kann der erste Nutzstromkontakt des zweiten Leistungshalbleiterbauelements, der in diesem Fall eine Source eines Feldeffekttransistors sein kann, an dem zweiten endseitigen Abschnitt der leitenden Schicht mittels der zweiten elektrischen Verbindung an die leitende Schicht angeschlossen werden. Die leitende Schicht nimmt das erste Potenzial an, welches in diesem Fall das kleinere Potenzial ist. Dabei nimmt die leitende Schicht neben der Trägerfunktion auch die Funktion eines Rückleiters des Stroms zu einer externen Schaltung, beispielsweise zu einem Zwischenkreis eines Umrichters, an. Diese Funktionalität sorgt für eine geringere Induktivität des Leistungshalbleiterbauelements zwischen dem ersten Kontakt und dem zweiten Kontakt, was in vielen Anwendungsfällen von Vorteil ist. Gleichzeitig sorgt die leitende Schicht für eine bessere Wärmespreizung und bessere Kühlung.

In einem anderen Ausführungsbeispiel ist eine zweite Polarität der Außenspannung vorgesehen, bei der das zweite Potenzial der Außenspannung kleiner ist als das erste Potenzial der Außenspannung. Bei der zweiten Polarität kann der erste Nutzstromkontakt des zweiten Leistungshalbleiterbauelements ebenfalls an dem zweiten endseitigen Abschnitt der leitenden Schicht mittels der zweiten elektrischen Verbindung an die leitende Schicht angeschlossen werden. In diesem Fall kann der erste Nutzstromkontakt ein Drain eines Feldeffekttransistors sein. Die leitende Schicht nimmt das erste Potenzial an, welches in diesem Fall das höhere Potenzial ist, so dass die leitende Schicht neben der Träger- und Kühlspreizfunktion auch eine Funktion eines Hinleiters des Stroms zwischen dem ersten Nutzstromkontakt des zweiten Leistungshalbleiterbauelements und dem ersten an der Trägeranordnung angeordnetem Kontakt annimmt.

Weiterhin kann ein Zwischenpotentialkontakt an der Trägeranordnung angeordnet sein, der dazu dient, ein Zwischenpotential mit einer externen Schaltung zu verbinden.

Ein wesentlicher Unterschied des erfindungsgemäßen Leistungshalbleiterbauteils im Vergleich zum aus der Praxis bekannten Leistungshalbleiterbauteil der Fig. 1 und 2 ist der, dass beide Leistungshalbleiterbauelemente auf derselben leitenden Schicht angeordnet sind. Damit entfallen die gegeneinander isolierten Metallträger, so dass sich die Herstellung des erfindungsgemäßen Leistungshalbleiterbauteils vereinfacht.

Da die nach außen weisende Fläche bei gleich bleibenden Gesamtabmessungen des Leistungshalbleiterbauteils größer sein kann, als die Summe der nach außen weisenden Flächen der Metallträger gemäß der Figur 1, ergibt sich zudem eine verbesserte Kühlung der beiden Leistungshalbleiterbauelemente.

Die Erfindung ermöglicht es, die leitende Schicht als geschlossene metallische Fläche auszuführen. Die geschlossene metallische Fläche kann dann den Zwischenpotenzialkontakt gegenüber einem Kühlkörper oder einer anderen leitenden Struktur, welche sich auf der anderen Seite der leitenden Schicht befindet, abschirmen. Somit wird die die elektromagnetische Verträglichkeit des Leistungshalbleiterbauteils verbessert.

Weil nun die leitende Schicht an ihren beiden endseitigen Abschnitten kontaktiert ist, übernimmt sie zudem die Funktion eines stromführenden Leiters des Leistungshalbleiterbauteils. Aufgrund des flächigen Charakters der leitenden Schicht kann diese niederohmiger und niederinduktiver sein als ein drahtförmiger Leiter oder eine schmale Leiterbahn, so dass sich geringere elektrische Verluste und ein besseres Schaltverhalten ergeben können. Darüber hinaus kann so die Anzahl der erforderlichen elektrischen Verbindungselemente in vielen Fällen verringert werden. Dadurch, dass der Strom zwischen dem ersten Kontakt und dem zweiten Kontakt in einer Schleife mit einer geringeren eigeschlossenen Fläche hin und zurück fließt ergibt sich eine geringere Induktivität zwischen dem ersten Kontakt und dem zweiten Kontakt, so dass sich ein besseres Schaltverhalten und geringere elektromagnetische Abstrahlung ergeben.

Ein weiterer Unterschied zum Stand der Technik ergibt sich daraus, dass bei dem erfindungsgemäßen Leistungshalbleiterbauteil der Zwischenpotentialkontakt der Halbbrücke, der das Zwischenpotenzial führt, potenzialmäßig von sämtlichen metallenen Bestandteilen der Trägeranordnung getrennt sein kann, so dass die leitenden Elemente, welche das Zwischenpotential aufweisen, eine geringere Oberfläche aufweisen, was zu einer geringeren kapazitiven Beaufschlagung des Zwischenpotentialkontaktes mit parasitären Kapazitäten zum Kühlkörper oder anderen umgebenden elektrischen Potentialen führt. Auf diese Weise kann eine Abstrahlung von elektromagnetischen Feldern in die Umgebung verringert sein. Weiterhin fließen bei jedem Schaltvorgang kleinere Verschiebungsströme zwischen Zwischenpotential und Kühlkörper.

Insgesamt übernimmt die leitende Schicht des erfindungsgemäßen Leistungshalbleiterbauteils in Bezug auf die beiden Leistungshalbleiterbauelemente die Aufgaben Befestigung, Kühlung, elektrische Verbindung und Abschirmung des Zwischenpotentials, wobei zusätzlich parasitäre Kapazitäten zwischen Zwischenpotentialkontakt und weiteren metallischen Bestandteilen der Anordnung, beispielsweise einem Außen an der Trägeranordnung angeordneten Kühlkörper, verringert sind.

Gemäß einer bevorzugten Weiterbildung der Erfindung ist mittels einer dritten elektrischen Verbindung der zweite Kontakt mit dem zweiten Nutzstromkontakt des ersten Leistungshalbleiterbauelements verbunden.

Bei der ersten Polarität der Außenspannung kann der zweite Nutzstromkontakt des ersten Leistungshalbleiterbauelements ein Drain eines Feldeffekttransistors sein.

Sofern die zweite Polarität der Außenspannung vorgesehen ist, kann der zweite Nutzstromkontakt des ersten Leistungshalbleiterbauelements eine Source eines Feldeffekttransistors sein.

Gemäß einer vorteilhaften Weiterbildung der Erfindung ist mittels einer vierten elektrischen Verbindung der erste Nutzstromkontakt des ersten Leistungshalbleiterbauelements mit dem zweiten Nutzstromkontakt des zweiten Leistungshalbleiterbauelements verbunden. Diese Verbindung kann das Zwischenpotential aufweisen.

Hierbei ist im ersten Ausführungsbeispiel die erste Polarität vorgesehen, so dass der erste Nutzstromkontakt des ersten Leistungshalbleiterbauelements eine Source eines Feldeffekttransistors sein kann, und so dass der zweite Nutzstromkontakt des zweiten Leistungshalbleiterbauelements ein Drain eines Feldeffekttransistors sein kann.

Dabei ist im zweiten Ausführungsbeispiel die zweite Polarität vorgesehen, so dass der erste Nutzstromkontakt des ersten Leistungshalbleiterbauelements ein Drain eines Feldeffekttransistors sein kann, und so dass der zweite Nutzstromkontakt des zweiten Leistungshalbleiterbauelements eine Source eines Feldeffekttransistors sein kann.

Gemäß einer vorteilhaften Weiterbildung der Erfindung weist das Trägersubstrat eine elektrisch isolierende Schicht auf, welche auf einer der nach außen weisenden Fläche gegenüberliegenden Seite der leitenden Schicht angeordnet ist.

Die elektrisch isolierende Schicht kann als funktionale Isolation des Aufbaus vom Kühlkörper dienen. Ebenso kann die isolierende Schicht als Sicherheitsisolation dienen. Als eine derartige isolierende Schicht kann ein organischer Isolator verwendet werden.

Nach einer zweckmäßigen Weiterbildung der Erfindung weist das Trägersubstrat eine weitere leitende Schicht auf, welche auf einer der nach außen weisenden Fläche gegenüberliegenden Seite der isolierenden Schicht angeordnet ist.

Die weitere leitende Schicht ist bevorzugt gegenüber der isolierenden Schicht elektrisch isoliert. Die weitere leitende Schicht kann insbesondere aus Metall sein und die Wärmeabfuhr des Leistungshalbleiterbauteils verbessern.

Das Trägersubstrat kann also eine leitende Schicht, eine elektrisch isolierende Schicht und eine weitere leitende Schicht aufweisen. Dabei kann das Trägersubstrat eine DBC (Direct Bonded Copper) Struktur, auch DCB (Direct Copper Bonded), ein IMS-Substrat (Insulated metal substrate) oder ein AMB-Substrat (active metal braze) sein. Diese ermöglichen eine optimale Wärmeableitung und sind technisch günstig herstellbar. Die leitende Schicht kann aus Kupfer, Aluminium oder beliebigem anderem leitendem Material sein.

Gemäß einer zweckmäßigen Weiterbildung der Erfindung ist an einer der nach außen weisenden Fläche gegenüberliegenden Fläche des Trägersubstrats ein Kühlkörper angeordnet.

Hierdurch kann die Kühlung der beiden Leistungshalbleiterbauelemente weiter verbessert werden.

Nach einer vorteilhaften Weiterbildung der Erfindung ist ferner vorgesehen:
ein drittes laterales Leistungshalbleiterbauelement, welches einen ersten Nutzstromkontakt und einen zweiten Nutzstromkontakt aufweist, welche beide an einer ersten Seite des dritten Leistungshalbleiterbauelements angeordnet sind, wobei das dritte Leistungshalbleiterbauelement ein Halbleitersubstrat aufweist, welches sich entlang einer der ersten Seite gegenüberliegenden zweiten Seite des dritten Leistungshalbleiterbauelements erstreckt; und
ein viertes laterales Leistungshalbleiterbauelement, welches einen ersten Nutzstromkontakt und einen zweiten Nutzstromkontakt aufweist, welche beide an einer ersten Seite des vierten Leistungshalbleiterbauelements angeordnet sind, wobei das vierte Leistungshalbleiterbauelement ein Halbleitersubstrat aufweist, welches sich entlang einer der ersten Seite gegenüberliegenden zweiten Seite des vierten Leistungshalbleiterbauelements erstreckt;
wobei das dritte Leistungshalbleiterbauelement und das vierte Leistungshalbleiterelement als weitere Halbbrücke verschaltet sind;
wobei wenigstens eines von dem dritten Leistungshalbleiterbauelement und dem vierten Leistungshalbleiterbauelement als schaltbares Leistungshalbleiterbauelement ausgebildet ist, welches einen Steuerkontakt aufweist, welcher an der ersten Seite des jeweiligen Leistungshalbleiterbauelements angeordnet ist;
wobei das dritte Leistungshalbleiterbauelement und das vierte Leistungshalbleiterelement mit ihrer jeweiligen zweiten Seite an der nach außen weisenden Fläche in der lateralen Richtung versetzt angeordnet sind;
wobei das dritte Leistungshalbleiterbauelement an dem ersten endseitigen Abschnitt der leitenden Schicht angeordnet und das vierte Leistungshalbleiterbauelement an dem zweiten endseitigen Abschnitt der leitenden Schicht angeordnet ist;
wobei der erste Nutzstromkontakt des vierten Leistungshalbleiterbauelements an dem zweiten endseitigen Abschnitt der leitenden Schicht mittels einer fünften elektrischen Verbindung an die leitende Schicht angeschlossen ist.

Auf diese Weise kann das Leistungshalbleiterbauteil als schaltbare Vollbrücke verwendet werden.

In einem Ausführungsbeispiel ist die erste Polarität der Außenspannung vorgesehen, bei der das zweite Potenzial der Außenspannung höher ist als das erste Potenzial der Außenspannung. Bei der ersten Polarität kann der erste Nutzstromkontakt des vierten Leistungshalbleiterbauelements, der in diesem Fall eine Source eines Feldeffekttransistors sein kann, an dem zweiten endseitigen Abschnitt der leitenden Schicht mittels einer fünften elektrischen Verbindung an die leitende Schicht angeschlossen werden. Die leitende Schicht nimmt das erste Potenzial an, welches in diesem Fall das kleinere Potenzial ist,. Dabei nimmt die leitende Schicht neben der Trägerfunktion auch die Funktion eines Rückleiters des Stroms der weiteren Halbbrücke zu einer externen Schaltung, beispielsweise zu einem Zwischenkreis eines Umrichters, an. Diese Funktionalität sorgt für eine geringere Induktivität des Leistungshalbleiterbauelements zwischen dem ersten Kontakt und dem zweiten Kontakt, was in vielen Anwendungsfällen von Vorteil ist. Gleichzeitig sorgt die leitende Schicht für eine bessere Wärmespreizung und bessere Kühlung.

In einem anderen Ausführungsbeispiel ist die zweite Polarität der Außenspannung vorgesehen, bei der das zweite Potenzial der Außenspannung tiefer ist als das erste Potenzial der Außenspannung. Bei der zweiten Polarität kann der erste Nutzstromkontakt des vierten Leistungshalbleiterbauelements ein Drain eines Feldeffekttransistors sein. Die leitende Schicht nimmt das erste Potenzial an, welches in diesem Fall das höhere Potenzial ist, so dass die leitende Schicht neben der Träger- und Kühlspreizfunktion auch eine Funktion eines Hinleiters des Stroms zwischen dem ersten Nutzstromkontakt des zweiten Leistungshalbleiterbauelements und dem ersten an der Trägeranordnung angeordnetem Kontakt annimmt.

Gemäß einer zweckmäßigen Weiterbildung der Erfindung ist mittels einer sechsten elektrischen Verbindung der zweite Kontakt mit dem zweiten Nutzstromkontakt des dritten Leistungshalbleiterbauelements verbunden.

Wenn dabei die erste Polarität der Außenspannung vorgesehen ist, kann der zweite Nutzstromkontakt des dritten Leistungshalbleiterbauelements ein Drain eines Feldeffekttransistors sein.

Sofern jedoch die zweite Polarität der Außenspannung vorgesehen ist, kann der zweite Nutzstromkontakt des dritten Leistungshalbleiterbauelements eine Source eines Feldeffekttransistors sein.

Nach einer zweckmäßigen Weiterbildung der Erfindung ist mittels einer siebten elektrischen Verbindung der erste Nutzstromkontakt des dritten Leistungshalbleiterbauelements mit dem zweiten Nutzstromkontakt des vierten Leistungshalbleiterbauelements verbunden.

Wenn die erste Polarität der Außenspannung vorgesehen ist, kann der erste Nutzstromkontakt des dritten Leistungshalbleiterbauelements eine Source eines Feldeffekttransistors und der zweite Nutzstromkontakt des vierten Leistungshalbleiterbauelements ein Drain eines Feldeffekttransistors sein.

Sofern jedoch die zweite Polarität der Außenspannung vorgesehen ist, kann der erste Nutzstromkontakt des dritten Leistungshalbleiterbauelements ein Drain eines Feldeffekttransistors und der zweite Nutzstromkontakt des vierten Leistungshalbleiterbauelements eine Source eines Feldeffekttransistors sein.

In einem Ausführungsbeispiel bilden das erste und das zweite Leistungshalbleiterbauelement eine erste Halbbrücke und das dritte und das vierte Leistungshalbleiterbauelement eine zweite Halbbrücke. In einem anderen Ausführungsbeispiel können eine oder mehrere weitere Halbbrücken vorgesehen sein, welche jeweils analog zur ersten bzw. zur zweiten Halbbrücke ausgebildet sein können. Beispielsweise kann eine dritte Halbbrücke vorgesehen sein, welche ein fünftes und ein sechstes Leistungshalbleiterbauelement umfasst.

Gemäß einer zweckmäßigen Weiterbildung der Erfindung ist das Halbleitersubstrat wenigstens eines der Leistungshalbleiterbauelemente leitfähig ausgebildet.

Das Halbleitersubstrat kann insbesondere aus leitfähigem Siliziumcarbid oder leitfähigem Silizium bestehen.

Im Vergleich zu nichtleitfähigen Halbleitersubstraten ergeben sich so Kostenvorteile.

Nach einer vorteilhaften Weiterbildung der Erfindung sind eine oder mehrere der besagten elektrischen Verbindungen als drahtgebondete Verbindung ausgebildet.

Drahtgebondete Verbindungen zeichnen sich insbesondere durch ihre leichte Herstellbarkeit aus.

Nach einer vorteilhaften Weiterbildung der Erfindung umfasst die Trägeranordnung eine Leiterplattenanordnung, in welche wenigstens eines der besagten Leistungshalbleiterbauelemente eingebettet ist, wobei eine oder mehrere der besagten elektrischen Verbindungen eine Leiterbahn der Leiterplattenanordnung und/oder eine Durchkontaktierung der Leiterplattenanordnung umfasst.

Unter einem in eine Leiterplattenanordnung eingebetteten Leistungshalbleiterbauelement wird ein solches Leistungshalbleiterbauelement verstanden, welches zu einem überwiegenden Teil, wenigstens jedoch zu einem wesentlichen Teil, von der Leiterplattenanordnung umhüllt ist. Unter einer Leiterplattenanordnung wird eine solche Anordnung verstanden, welche wenigstens eine flache elektrisch isolierende Schicht umfasst, an der Leiterbahnen ausgebildet sind.

Unter einer Durchkontaktierung wird eine elektrische Verbindung verstanden, welche wenigstens teilweise durch eine der isolierenden Schichten hindurch wirksam ist.

In einem Ausführungsbeispiel kann die Leiterplattenanordnung beispielsweise aus dem Werkstoff FR4 bestehen. FR-4 oder auch FR4 bezeichnet eine Klasse von schwer entflammbaren und flammenhemmenden Verbundwerkstoffen bestehend aus Epoxidharz und Glasfasergewebe.

Die Einbettung der besagten Leistungshalbleiterbauelemente erlaubt einen stabilen und kompakten Aufbau, was aufgrund von kurzen Leitungslängen auch zu elektrischen Vorteilen, nämlich zu geringen ohmschen Verlusten und zu geringen unerwünschten induktiven und kapazitiven Belägen, führen kann.

Nach einer vorteilhaften Weiterbildung der Erfindung sind der erste Kontakt und der zweite Kontakt in der lateralen Richtung gesehen an einem selben endseitigen Bereich des Leistungshalbleiterbauteils angeordnet.

Unter einem endseitigen Bereich des Leistungshalbleiterbauteils kann dabei in einem weiteren Sinn ein Bereich verstanden werden, der sich in der lateralen Richtung gesehen an einem Ende des Leistungshalbleiterbauteils des Leistungshalbleiterbauteils erstreckt. In einem engeren Sinn kann unter dem endseitigen Bereich ein Bereich verstanden werden, der sich von dem jeweiligen Ende des Leistungshalbleiterbauteils in der lateralen Richtung gesehen des Leistungshalbleiterbauteils erstreckt.

Die Vorteile einer derartigen Anordnung des ersten Kontakts und des zweiten Kontakts liegen insbesondere darin, dass der Anschluss des ersten und zweiten Kontaktes erleichtert wird, und das auf dem jeweils anderen endseitigen Bereich über den Leistungshalbleiterelementen ein freier Raum zur Anordnung von anderen Bauelementen geschaffen wird.

Gemäß einer vorteilhaften Weiterbildung der Erfindung ist auf einem dem Trägersubstrat abgewandten Seite des Leistungshalbleiterbauteils an dem endseitigen Bereich des Leistungshalbleiterbauteils ein Kondensator angeordnet.

Bei dem Kondensator kann es sich insbesondere um einen Zwischenkreiskondensator eines Umrichters, eines Gleichspannungswandlers oder eines Frequenzumrichters handeln.

Der Kondensator kann dabei mit kurzen Leitungslängen oder sogar direkt mit dem ersten Kontakt und dem zweiten Kontakt verbunden werden.

Nach einer zweckmäßigen Weiterbildung der Erfindung ist auf der dem Trägersubstrat abgewandten Seite des Leistungshalbleiterbauteils in der lateralen Richtung gesehen in einem Bereich des ersten Leistungshalbleiterbauelements und des zweiten Leistungshalbleiterbauelements wenigstens ein Teil eines Treibers angeordnet, der zum Schalten des wenigstens einen schaltbaren Leistungshalbleiterbauelements der Leistungshalbleiterbauelemente ausgebildet ist.

In einem Ausführungsbeispiel ist der Treiber über eine Durchkontaktierung mit dem Steuerkontakt des ersten Leistungshalbleiterbauelements und über eine weitere Durchkontaktierung mit dem Steuerkontakt des zweiten Leistungshalbleiterbauelements verbunden. Bei der Durchkontaktierung und bei der weiteren Durchkontaktierung könnte es sich jedoch auch um andere elektrische Verbindungen handeln.

Die erfindungsgemäße Anordnung des Treibers ermöglicht geringe Leitungslängen beziehungsweise geringe Impedanz und insbesondere geringe Induktivität der Zuleitung zum Anschließen des Treibers an die Leistungshalbleiterbauelemente.

In einem weiteren Aspekt wird die Aufgabe gelöst durch einen Verfahren zum Herstellen eines Leistungshalbleiterbauteils, welches folgende Schritte umfasst:
Bereitstellen eines ersten lateralen Leistungshalbleiterbauelements, welches einen ersten Nutzstromkontakt und einen zweiten Nutzstromkontakt aufweist, welche beide an einer ersten Seite des ersten Leistungshalbleiterbauelements angeordnet sind, wobei das erste Leistungshalbleiterbauelement ein Halbleitersubstrat aufweist, welches sich entlang einer der ersten Seite gegenüberliegenden zweiten Seite des ersten Leistungshalbleiterbauelements erstreckt;
Bereitstellen eines zweiten lateralen Leistungshalbleiterbauelements, welches einen ersten Nutzstromkontakt und einen zweiten Nutzstromkontakt aufweist, welche beide an einer ersten Seite des zweiten Leistungshalbleiterbauelements angeordnet sind, wobei das zweite Leistungshalbleiterbauelement ein Halbleitersubstrat aufweist, welches sich entlang einer der ersten Seite gegenüberliegenden zweiten Seite des zweiten Leistungshalbleiterbauelements erstreckt;
Bereitstellen einer Trägeranordnung, welche ein Trägersubstrat aufweist, welches eine leitende Schicht mit einer nach außen weisenden Fläche umfasst;
Anordnen eines ersten Kontakts an der Trägeranordnung, welcher zum Anschließen eines ersten Potentials einer Außenspannung an eine externe Schaltung vorgesehen ist; und
Anordnen eines zweiten Kontakts an der Trägeranordnung, welcher zum Anschließen eines zweiten Potentials der Außenspannung an die externe Schaltung vorgesehen ist;
wobei die besagten Leistungshalbleiterbauelemente als Halbbrücke verschaltet werden;
wobei wenigstens eines der besagten Leistungshalbleiterbauelemente als schaltbares Leistungshalbleiterbauelement ausgebildet ist, welches einen Steuerkontakt aufweist, welcher an der ersten Seite des jeweiligen Leistungshalbleiterbauelements angeordnet ist;
wobei das erste Leistungshalbleiterbauelement und das zweite Leistungshalbleiterelement mit ihrer jeweiligen zweiten Seite an der nach außen weisenden Fläche in einer lateralen Richtung versetzt angeordnet werden;
wobei das erste Leistungshalbleiterbauelement an einem in der lateralen Richtung gesehen ersten endseitigen Abschnitt der leitenden Schicht angeordnet und das zweite Leistungshalbleiterbauelement an einem dem ersten endseitigen Abschnitt in der lateralen Richtung gesehen gegenüberliegenden zweiten endseitigen Abschnitt der leitenden Schicht angeordnet wird;
wobei der erste Kontakt an dem ersten endseitigen Abschnitt der leitenden Schicht mittels einer ersten elektrischen Verbindung an die leitende Schicht angeschlossen wird;
wobei der erste Nutzstromkontakt des zweiten Leistungshalbleiterbauelements an dem zweiten endseitigen Abschnitt der leitenden Schicht mittels einer zweiten elektrischen Verbindung an die leitende Schicht angeschlossen wird.

Im Folgenden werden die vorliegende Erfindung und deren Vorteile anhand von Figuren näher beschrieben. Es zeigen:
- Fig. 1: ein Leistungshalbleiterbauteil gemäß dem Stand der Technik in einer teilweise geschnittenen Seitenansicht;
- Fig. 2: einen Schaltplan des Leistungshalbleiterbauteils der Fig. 1;
- Fig. 3: eine schematische Darstellung eines ersten Ausführungsbeispiels eines erfindungsgemäßen Leistungshalbleiterbauteils in einer teilweise geschnittenen Seitenansicht;
- Fig. 4: einen Schaltplan des Leistungshalbleiterbauteils der Fig. 3;
- Fig. 5: eine schematische Darstellung eines zweiten Ausführungsbeispiels eines erfindungsgemäßen Leistungshalbleiterbauteils in einer teilweise geschnittenen Seitenansicht;
- Fig. 6: einen Schaltplan des Leistungshalbleiterbauteils der Fig. 5;
- Fig. 7: eine schematische Darstellung eines ersten Ausführungsbeispiels eines schaltbaren lateralen Leistungshalbleiterbauelements für ein erfindungsgemäßes Leistungshalbleiterbauteil in einer teilweise geschnittenen Seitenansicht;
- Fig. 8: eine schematische Darstellung eines zweiten Ausführungsbeispiels eines schaltbaren lateralen Leistungshalbleiterbauelements für ein erfindungsgemäßes Leistungshalbleiterbauteil in einer teilweise geschnittenen Seitenansicht;
- Fig. 9: zum Vergleich eine schematische Darstellung eines Ausführungsbeispiels eines schaltbaren vertikalen Leistungshalbleiterbauelements, welches für ein erfindungsgemäßes Leistungshalbleiterbauteil ungeeignet ist, in einer teilweise geschnittenen Seitenansicht;
- Fig. 10: eine schematische Darstellung eines Ausführungsbeispiels eines nicht schaltbaren lateralen Leistungshalbleiterbauelements für ein erfindungsgemäßes Leistungshalbleiterbauteil in einer teilweise geschnittenen Seitenansicht;
- Fig. 11: eine schematische Darstellung eines dritten Ausführungsbeispiels eines erfindungsgemäßen Leistungshalbleiterbauteils in einer teilweise geschnittenen Seitenansicht;
- Fig. 12: eine schematische Darstellung eines vierten Ausführungsbeispiels eines erfindungsgemäßen Leistungshalbleiterbauteils in einer teilweise geschnittenen Seitenansicht;
- Fig. 13: einen Schaltplan des Leistungshalbleiterbauteils der Fig. 12;
- Fig. 14: eine schematische Darstellung eines fünften Ausführungsbeispiels eines erfindungsgemäßen Leistungshalbleiterbauteils in einer teilweise geschnittenen Seitenansicht.

Gleiche oder gleichartige Elemente oder Elemente mit gleicher oder äquivalenter Funktion sind im Folgenden mit gleichen oder gleichartigen Bezugszeichen versehen.

In der folgenden Beschreibung werden Ausführungsbeispiele mit einer Vielzahl von Merkmalen der vorliegenden Erfindung näher beschrieben, um ein besseres Verständnis der Erfindung zu vermitteln. Es ist jedoch festzuhalten, dass die vorliegende Erfindung auch unter Auslassung einzelner der beschriebenen Merkmale umgesetzt werden kann. Es sei auch darauf hingewiesen, dass die in verschiedenen Ausführungsbeispielen gezeigten Merkmale auch in anderer Weise kombinierbar sind, sofern dies nicht ausdrücklich ausgeschlossen ist oder zu Widersprüchen führen würde.

Fig. 1 zeigt ein Leistungshalbleiterbauteil 1 gemäß dem Stand der Technik in einer teilweise geschnittenen Seitenansicht. Leistungshalbleiterbauteil umfasst:
ein erstes laterales Leistungshalbleiterbauelement 2, welches einen ersten Nutzstromkontakt 3 und einen zweiten Nutzstromkontakt 4 aufweist, welche beide an einer ersten Seite 5 des ersten Leistungshalbleiterbauelements 2 angeordnet sind, wobei das erste Leistungshalbleiterbauelement 2 ein Halbleitersubstrat 6 aufweist, welches sich entlang einer der ersten Seite 5 gegenüberliegenden zweiten Seite 7 des ersten Leistungshalbleiterbauelements 2 erstreckt; und
ein zweites laterales Leistungshalbleiterbauelement 8, welches einen ersten Nutzstromkontakt 9 und einen zweiten Nutzstromkontakt 10 aufweist, welche beide an einer ersten Seite 11 des zweiten Leistungshalbleiterbauelements 8 angeordnet sind, wobei das zweite Leistungshalbleiterbauelement 8 ein Halbleitersubstrat 12 aufweist, welches sich entlang einer der ersten Seite 11 gegenüberliegenden zweiten Seite 13 des zweiten Leistungshalbleiterbauelements 8 erstreckt wobei die besagten Leistungshalbleiterbauelemente 2, 8 als Halbbrücke verschaltet sind.

Weiterhin umfasst das Leistungshalbleiterbauteil 1 eine Trägeranordnung 14, welches das erste laterale Leistungshalbleiterbauelement 2 und das zweite laterale Leistungshalbleiterbauelement 8 trägt.

Darüber hinaus ist ein erster an der Trägeranordnung 14 angeordneter Kontakt 15 zum Anschließen eines ersten Potentials U1 einer externen Versorgungsspannung U und ein zweiter an der Trägeranordnung 14 angeordneter Kontakt 16 zum Anschließen eines zweiten Potentials U2 der externen Versorgungsspannung U vorgesehen.

Weiterhin ist ein Ausgangkontakt 17 an der Trägeranordnung 14 angeordnet, der dazu dient, ein Ausgangssignal AS an eine nicht gezeigte Schaltung weiterzuleiten.

Das erste Leistungshalbleiterbauelement 2 weist darüber hinaus einen Schalteingang 18 auf und das zweite Leistungshalbleiterbauelement 8 weist einen Schalteingang 19 auf. Dabei ist das erste Leistungshalbleiterbauelement 2 mit seiner zweiten Seite an einem ersten Metallträger 20 der Trägeranordnung 14 und das zweite Leistungshalbleiterbauelement 2 mit seiner zweiten Seite an einem zweiten Metallträger 21 der Trägeranordnung 14 angeordnet. Der erste Metallträger 20 und der zweite Metallträger 21 sind dabei an einem Rahmen 22 der Trägeranordnung 14 festgelegt.

Der zweite Kontakt 16 ist mit dem zweiten Nutzstromkontakt 4 des ersten Leistungshalbleiterbauelements 2 elektrisch leitend verbunden. Weiterhin ist der Ausgangskontakt 17 elektrisch leitend mit dem ersten Nutzstromkontakt 3 des ersten Leistungshalbleiterbauelements 2, mit dem zweite Nutzstromkontakt 10 des zweiten Leistungshalbleiterbauelements 8 und dem ersten Metallträger 20 elektrisch leitend verbunden. Hierdurch liegt das Potenzial des ersten Metallträgers 20 und des Halbleitersubstrats 6 des ersten Leistungshalbleiterbauelements 2, sofern dieses elektrisch leitend ist, auf demselben Potenzial wie der Ausgangskontakt 17. Darüber hinaus ist der erste Kontakt 15 mit dem ersten Nutzstromkontakt 9 des zweiten Leistungshalbleiterbauelements 8 und mit dem zweiten Metallträger 21 elektrisch leitend verbunden. Daher liegt das Potenzial des zweiten Metallträgers 21 und des Halbleitersubstrats 12, sofern dieses elektrisch leitend ist, auf demselben Potenzial wie der erste Kontakt 15. Damit der Zwischenpotentialkontakt 17 und der erste Kontakt 15 durch Trägeranordnung 14 nicht kurz geschlossen werden, sind der erste Metallträger 20 und der zweite Metallträger 21 getrennt voneinander ausgebildet und elektrisch gegeneinander isoliert.

Fig. 2 zeigt einen Schaltplan des Leistungshalbleiterbauteils 1 der Fig. 1.

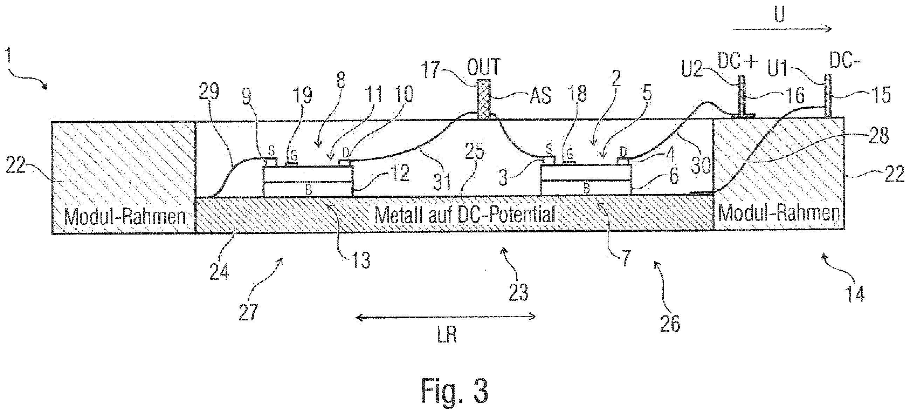

Fig. 3 zeigt eine schematische Darstellung eines ersten Ausführungsbeispiels eines erfindungsgemäßen Leistungshalbleiterbauteils 1 in einer teilweise geschnittenen Seitenansicht, welches folgende Merkmale umfasst:
ein erstes laterales Leistungshalbleiterbauelement 2, welches einen ersten Nutzstromkontakt 3 und einen zweiten Nutzstromkontakt 4 aufweist, welche beide an einer ersten Seite 5 des ersten Leistungshalbleiterbauelements 2 angeordnet sind, wobei das erste Leistungshalbleiterbauelement 2 ein Halbleitersubstrat 6 aufweist, welches sich entlang einer der ersten Seite 5 gegenüberliegenden zweiten Seite 7 des ersten Leistungshalbleiterbauelements 2 erstreckt;
ein zweites laterales Leistungshalbleiterbauelement 8, welches einen ersten Nutzstromkontakt 9 und einen zweiten Nutzstromkontakt 10 aufweist, welche beide an einer ersten Seite 11 des zweiten Leistungshalbleiterbauelements 8 angeordnet sind, wobei das zweite Leistungshalbleiterbauelement 8 ein Halbleitersubstrat 12 aufweist, welches sich entlang einer der ersten Seite 11 gegenüberliegenden zweiten Seite 13 des zweiten Leistungshalbleiterbauelements 8 erstreckt;
eine Trägeranordnung 14, welche ein Trägersubstrat 23 aufweist, welches eine leitende Schicht 24 mit einer nach außen weisenden Fläche 25 umfasst;
ein erster an der Trägeranordnung 14 angeordneter Kontakt 15 zum Anschließen eines ersten Potentials U1 einer Außenspannung U an eine externe Schaltung ; und
ein zweiter an der Trägeranordnung 14 angeordneter Kontakt 16 zum Anschließen eines zweiten Potentials U2 der Außenspannung an die externe Schaltung U;
wobei die besagten Leistungshalbleiterbauelemente 2, 8 als Halbbrücke verschaltet sind;
wobei wenigstens eines der besagten Leistungshalbleiterbauelemente 2, 8 als schaltbares Leistungshalbleiterbauelement 2, 8 ausgebildet ist, welches einen Steuerkontakt 18, 19 aufweist, welcher an der ersten Seite 5, 11 des jeweiligen Leistungshalbleiterbauelements 2, 8 angeordnet ist;
wobei das erste Leistungshalbleiterbauelement 2 und das zweite Leistungshalbleiterelement 8 mit ihrer jeweiligen zweiten Seite 7, 13 an der nach außen weisenden Fläche 25 in einer lateralen Richtung LR versetzt angeordnet sind;
wobei das erste Leistungshalbleiterbauelement 2 an einem in der lateralen Richtung LR gesehen ersten endseitigen Abschnitt 26 der leitenden Schicht 24 angeordnet und das zweite Leistungshalbleiterbauelement 8 an einem dem ersten endseitigen Abschnitt 26 in der lateralen Richtung LR gesehen gegenüberliegenden zweiten endseitigen Abschnitt 27 der leitenden Schicht 24 angeordnet ist;
wobei der erste Kontakt 15 an dem ersten endseitigen Abschnitt 26 der leitenden Schicht 24 mittels einer ersten elektrischen Verbindung 28 an die leitende Schicht 24 angeschlossen ist;
wobei der erste Nutzstromkontakt 9 des zweiten Leistungshalbleiterbauelements 8 an dem zweiten endseitigen Abschnitt 27 der leitenden Schicht 24 mittels einer zweiten elektrischen Verbindung 29 an die leitende Schicht 24 angeschlossen ist.

Da wenigstens eines der besagten Leistungshalbleiterbauelemente 2, 8 als schaltbares Leistungshalbleiterbauelement 2, 8 ausgebildet ist, kann die gebildete Halbbrücke auch als schaltbare Halbbrücke bezeichnet werden. Im Ausführungsbeispiel der Fig. 3 sind beide der besagten Leistungshalbleiterbauelemente schaltbar ausgeführt. Es wäre jedoch auch möglich, das erste Leistungshalbleiterbauelement 2 schaltbar und das zweite Leistungshalbleiterbauelement 8 nicht schaltbar auszuführen. Ebenso wäre es möglich, das erste Leistungshalbleiterbauelement 2 nicht schaltbar und das zweite Leistungshalbleiterbauelement 8 schaltbar auszuführen.

Der Steuerkontakt 18 des ersten Leistungshalbleiterbauelements 2 und der Steuerkontakt 19 des zweiten Leistungshalbleiterbauelements 8 können mit einem Treiber des Leistungshalbleiterbauteils 1 oder mit einem externen Treiber sein, wobei der jeweilige Treiber zum Schalten des 1. und des 2. Leistungshalbleiterbauelements 2, 8 ausgebildet sein kann.

Im Ausführungsbeispiel der Fig. 3 umfasst die Trägeranordnung 14 den Rahmen 22 und die leitende Schicht 24, welche mechanisch miteinander verbunden sind.

Die beiden Leistungshalbleiterbauelemente 2, 8 sind bevorzugt so an der nach außen weisenden Fläche 25 angeordnet, dass ein Wärmefluss von dem jeweiligen Leistungshalbleiterbauelements 2, 8 zu der leitenden Schicht 24 möglich ist.

Unter einem ersten endseitigen Abschnitt 26 der leitenden Schicht 24 kann dabei in einem weiteren Sinn ein Abschnitt verstanden werden, der sich in der lateralen Richtung LR gesehen von einem ersten Ende der leitenden Schicht 24 bis zur Mitte der leitenden Schicht 24 erstreckt. Analog kann unter einem zweiten endseitigen Abschnitt 27 in einem weiteren Sinn ein Abschnitt verstanden werden, der sich in der lateralen Richtung LR gesehen von einem anderen Ende der leitenden Schicht 24 bis zum Mitte der leitenden Schicht 24 erstreckt. In einem engeren Sinn kann unter dem ersten endseitigen Abschnitt 26 ein Abschnitt verstanden werden, der sich von dem ersten Ende der leitenden Schicht 24 in der lateralen Richtung LR gesehen über ein Drittel der Gesamtlänge der leitenden Schicht 24 erstreckt. Ebenso kann unter dem zweiten endseitigen Abschnitt 27 ein Abschnitt verstanden werden, der sich von dem zweiten Ende der leitenden Schicht 24 in der lateralen Richtung LR gesehen über ein Drittel der Gesamtlänge der leitenden Schicht 24 erstreckt.

Im Ausführungsbeispiel der Fig. 3 ist eine erste Polarität der Außenspannung U vorgesehen, bei der das zweite Potenzial U2 der Außenspannung U größer ist als das erste Potenzial U1 der Außenspannung. Bei der ersten Polarität kann der erste Nutzstromkontakt 9 des zweiten Leistungshalbleiterbauelements 8 eine Source eines Feldeffekttransistors 8 sein. Die leitende Schicht 24 nimmt das erste Potenzial U1 an, welches in diesem Fall das kleinere Potenzial ist, so dass die leitende Schicht 24 die Funktion eines Rückleiters des Stroms zu einer externen Schaltung, beispielsweise ein Zwischenkreis eines Stromrichters annimmt. Dabei nimmt die leitende Schicht 24 neben der Trägerfunktion auch die Funktion eines Rückleiters des Stroms zu einer externen Schaltung, beispielsweise zu einem Zwischenkreis eines Umrichters, an. Diese Funktionalität sorgt für eine geringere Induktivität des Leistungshalbleiterbauelements 1 zwischen dem ersten Kontakt 15 und dem zweiten Kontakt 16, was in vielen Anwendungsfällen von Vorteil ist. Gleichzeitig sorgt die leitende Schicht 24 für eine bessere Wärmespreizung und bessere Kühlung.

Weiterhin kann ein Zwischenpotentialkontakt 17 an der Trägeranordnung 14 angeordnet sein, der dazu dient, ein Zwischenpotential AS mit einer nicht gezeigten Schaltung zu verbinden.

Ein wesentlicher Unterschied des erfindungsgemäßen Leistungshalbleiterbauteils 1 im Vergleich zum aus der Praxis bekannten Leistungshalbleiterbauteil 1 der Fig. 1 und 2 ist der, dass beide Leistungshalbleiterbauelemente 2, 8 auf derselben leitenden Schicht 24 angeordnet sind. Damit entfallen die gegeneinander isolierten Metallträger 20 und 21, so dass sich die Herstellung des erfindungsgemäßen Leistungshalbleiterbauteils 1 vereinfacht.

Da die nach außen weisende Fläche 25 bei gleich bleibenden Gesamtabmessungen des Leistungshalbleiterbauteils 1 größer sein kann, als die Summe der nach außen weisenden Flächen der Metallträger 20 und 21, ergibt sich zudem eine verbesserte Kühlung der beiden Leistungshalbleiterbauelemente 2, 8.

Die Erfindung ermöglicht es, die leitende Schicht 24 als geschlossene metallische Fläche auszuführen. Die geschlossene leitende Schicht 24 kann dann den Zwischenpotenzialkontakt 17 gegenüber einem Kühlkörper oder einer anderen leitenden Struktur, welche sich auf der anderen Seite der leitenden Schicht 24 befindet, abschirmen. Somit wird die die elektromagnetische Verträglichkeit des Leistungshalbleiterbauteils 1 verbessert..

Weil nun die leitende Schicht 24 an ihren beiden endseitigen Abschnitten 26 und 27 kontaktiert ist, übernimmt sie zudem die Funktion eines stromführenden Leiters des Leistungshalbleiterbauteils 1. Aufgrund des flächigen Charakters der leitenden Schicht 24 kann diese niederohmiger sein als ein drahtförmiger Leiter oder eine schmale Leiterbahnen an einer Leiterplatte, so dass sich geringere elektrische Verluste ergeben können. Darüber hinaus kann so die Anzahl der erforderlichen elektrischen Verbindungselemente in vielen Fällen verringert werden. Dadurch, dass der Strom zwischen dem ersten Kontakt 15 und dem zweiten Kontakt 16 in einer Schleife mit einer geringeren eigeschlossenen Fläche hin und zurück fließt ergibt sich eine geringere Induktivität zwischen dem ersten Kontakt 15 und dem zweiten Kontakt 16, so dass sich ein besseres Schaltverhalten und geringere Abstrahlung ergeben.

Ein weiterer Unterschied zum Stand der Technik ergibt sich daraus, dass bei dem erfindungsgemäßen Leistungshalbleiterbauteil 1 der Mittenabgriff der Halbbrücke, der das Zwischenpotential AS führt, potenzialmäßig von sämtlichen metallenen Bestandteilen der Trägeranordnung 14 getrennt sein kann, so dass die leitenden Elemente, welche das Zwischenpotential AS aufweisen, eine geringere Oberfläche aufweisen, was zu einer geringeren kapazitiven Beaufschlagung des Zwischenpotentialkontaktes 17 mit parasitären Kapazitäten zum Kühlkörper oder anderen umgebenden elektrischen Potentialen führt. Auf diese Weise kann eine Abstrahlung von elektromagnetischen Feldern in die Umgebung verringert sein. Weiterhin fließen bei jedem Schaltvorgang kleinere Verschiebungsströme zwischen Zwischenpotential und Kühlkörper.

Insgesamt übernimmt die leitende Schicht 24 des erfindungsgemäßen Leistungshalbleiterbauteils in Bezug auf die beiden Leistungshalbleiterbauelemente 2, 8 die Aufgaben Befestigung, Kühlung, elektrische Verbindung und Abschirmung des Zwischenpotentiales AS, wobei zusätzlich parasitäre Kapazitäten in Bezug auf das Zwischenpotential AS verringert sind.

Gemäß einer bevorzugten Weiterbildung der Erfindung ist mittels einer dritten elektrischen Verbindung 30 der zweite Kontakt 16 mit dem zweiten Nutzstromkontakt 4 des ersten Leistungshalbleiterbauelements 2 verbunden.

Im Ausführungsbeispiel der Fig. 3 ist die erste Polarität der Außenspannung U vorgesehen, bei der das zweite Potenzial U2 der Außenspannung U größer ist als das erste Potenzial U1 der Außenspannung U. Bei der ersten Polarität der Außenspannung U kann der zweite Nutzstromkontakt 4 des ersten Leistungshalbleiterbauelements 2 ein Drain eines Feldeffekttransistors 2 sein.

Gemäß einer zweckmäßigen Weiterbildung der Erfindung ist mittels einer vierten elektrischen Verbindung 31 der erste Nutzstromkontakt 3 des ersten Leistungshalbleiterbauelements 2 mit dem zweiten Nutzstromkontakt 10 des zweiten Leistungshalbleiterbauelements 8 verbunden. Diese Verbindung kann das Zwischenpotential AS aufweisen.

Dabei ist im Ausführungsbeispiel der Fig. 3 die erste Polarität der Außenspannung U vorgesehen, so dass der erste Nutzstromkontakt 3 des ersten Leistungshalbleiterbauelements 2 eine Source eines Feldeffekttransistors 2 und der zweite Nutzstromkontakt 10 des zweiten Leistungshalbleiterbauelements 8 ein Drain eines Feldeffekttransistors 8 sein kann.

In einem weiteren Aspekt betrifft Erfindung ein Verfahren zum Herstellen einer Leistungshalbleiterbauteil 1, welches folgende Schritte umfasst:
Bereitstellen eines ersten lateralen Leistungshalbleiterbauelements 2, welches einen ersten Nutzstromkontakt 3 und einen zweiten Nutzstromkontakt 4 aufweist, welche beide an einer ersten Seite 5 des ersten Leistungshalbleiterbauelements 2 angeordnet sind, wobei das erste Leistungshalbleiterbauelement 2 ein Halbleitersubstrat 6 aufweist, welches sich entlang einer der ersten Seite 5 gegenüberliegenden zweiten Seite 7 des ersten Leistungshalbleiterbauelements 2 erstreckt;
Bereitstellen eines zweiten lateralen Leistungshalbleiterbauelements 8, welches einen ersten Nutzstromkontakt 9 und einen zweiten Nutzstromkontakt 10 aufweist, welche beide an einer ersten Seite 11 des zweiten Leistungshalbleiterbauelements 8 angeordnet sind, wobei das zweite Leistungshalbleiterbauelement 8 ein Halbleitersubstrat 12 aufweist, welches sich entlang einer der ersten Seite 11 gegenüberliegenden zweiten Seite 13 des zweiten Leistungshalbleiterbauelements 8 erstreckt;
Bereitstellen einer Trägeranordnung 14, welche ein Trägersubstrat 23 aufweist, welches eine leitende Schicht 24 mit einer nach außen weisenden Fläche 25 umfasst;
Anordnen eines ersten Kontakts 15 an der Trägeranordnung 14, welcher zum Anschließen eines ersten Potentials U1 einer Außenspannung U an eine externe Schaltung vorgesehen ist; und
Anordnen eines zweiten Kontakts 16 an der Trägeranordnung 14, welcher zum Anschließen eines zweiten Potentials U2 der Außenspannung U an die externe Schaltung vorgesehen ist;
wobei die besagten Leistungshalbleiterbauelemente 2, 8 als Halbbrücke verschaltet werden;
wobei wenigstens eines der besagten Leistungshalbleiterbauelemente 2, 8 als schaltbares Leistungshalbleiterbauelement 2, 8 ausgebildet ist, welches einen Steuerkontakt 18, 19 aufweist, welcher an der ersten Seite 5, 11 des jeweiligen Leistungshalbleiterbauelements 2, 8 angeordnet ist;
wobei das erste Leistungshalbleiterbauelement 2 und das zweite Leistungshalbleiterelement 8 mit ihrer jeweiligen zweiten Seite 7, 13 an der nach außen weisenden Fläche 25 in einer lateralen Richtung LR versetzt angeordnet werden;
wobei das erste Leistungshalbleiterbauelement 2 an einem in der lateralen Richtung LR gesehen ersten endseitigen Abschnitt 26 der leitenden Schicht 24 angeordnet und das zweite Leistungshalbleiterbauelement 8 an einem dem ersten endseitigen Abschnitt 26 in der lateralen Richtung LR gesehen gegenüberliegenden zweiten endseitigen Abschnitt 27 der leitenden Schicht 24 angeordnet wird;
wobei der erste Kontakt 15 an dem ersten endseitigen Abschnitt 26 der leitenden Schicht 24 mittels einer ersten elektrischen Verbindung 28 an die leitende Schicht 24 angeschlossen wird;
wobei der erste Nutzstromkontakt 9 des zweiten Leistungshalbleiterbauelements 8 an dem zweiten endseitigen Abschnitt 27 der leitenden Schicht 24 mittels einer zweiten elektrischen Verbindung 29 an die leitende Schicht 24 angeschlossen wird.

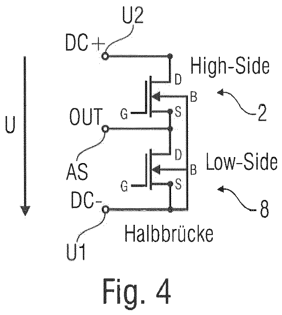

Fig. 4 zeigt einen Schaltplan des Leistungshalbleiterbauteils 1 der Fig. 3.

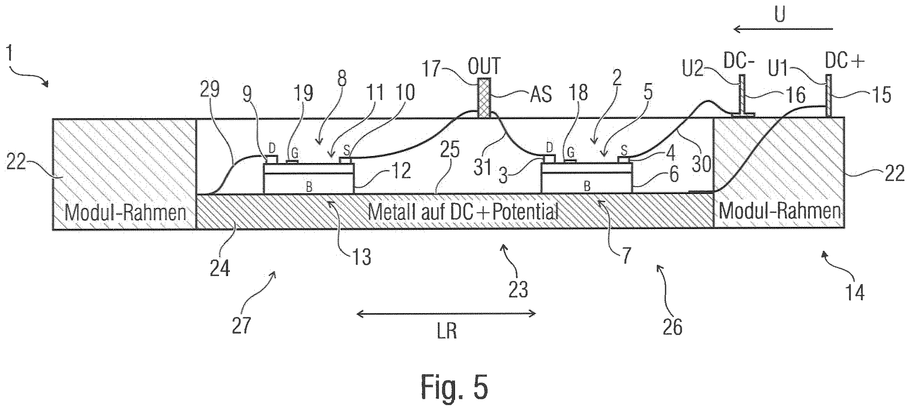

Fig. 5 zeigt eine schematische Darstellung eines zweiten Ausführungsbeispiels eines erfindungsgemäßen Leistungshalbleiterbauteils 1 in einer teilweise geschnittenen Seitenansicht. Das dritte Ausführungsbeispiel beruht auf dem ersten Ausführungsbeispiel der Fig. 3 und 4, wobei im Folgenden lediglich die Unterschiede beschrieben sind.

Im Ausführungsbeispiel der Fig. 5 ist eine zweite Polarität der Außenspannung U vorgesehen, bei der das zweite Potenzial U2 der Außenspannung U kleiner ist als das erste Potenzial U1 der Außenspannung U. Bei der zweiten Polarität kann der erste Nutzstromkontakt 9 des zweiten Leistungshalbleiterbauelements 8 ein Drain eines Feldeffekttransistors 8 sein. Die leitende Schicht 24 nimmt das erste Potenzial U1 an, welches in diesem Fall das größere Potenzial ist, so dass die leitende Schicht 24 neben der Träger- und Kühlspreizfunktion auch eine Funktion eines Hinleiters des Stroms zwischen dem ersten Nutzstromkontakt des zweiten Leistungshalbleiterbauelements und dem ersten an der Trägeranordnung angeordnetem Kontakt annimmt.

Da im Ausführungsbeispiel der Fig. 5 die zweite Polarität der Außenspannung U vorgesehen ist, kann der zweite Nutzstromkontakt 4 des ersten Leistungshalbleiterbauelements 2 eine Source eines Feldeffekttransistors 2 sein.

Dabei ist im Ausführungsbeispiel der Fig. 5 kann aus demselben Grund der erste Nutzstromkontakt 3 des ersten Leistungshalbleiterbauelements 2 ein Drain eines Feldeffekttransistors 2 sein und der Nutzstromkontakt 10 des zweiten Leistungshalbleiterbauelements 8 eine Source eines Feldeffekttransistors 8 sein.

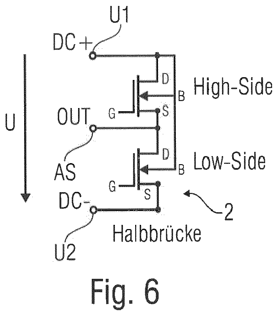

Fig. 6 zeigt einen Schaltplan des Leistungshalbleiterbauteils 1 der Fig. 5.

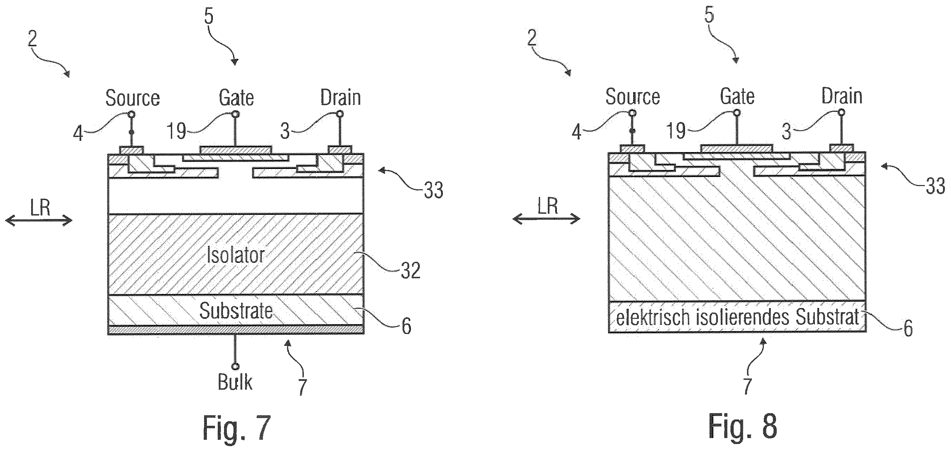

Fig. 7 zeigt eine schematische Darstellung eines ersten Ausführungsbeispiels eines schaltbaren lateralen Leistungshalbleiterbauelements 2 für ein erfindungsgemäßes Leistungshalbleiterbauteil 1 in einer teilweise geschnittenen Seitenansicht.

Bei dem schaltbaren lateralen Leistungshalbleiterbauelement 2, kann es sich um einen Transistor 2, insbesondere um einen Feldeffekttransistor (FET) handeln. Bevorzugt kann ein Sperrschicht-Feldeffekt-Transistor (JFET), ein Schottky-Feldeffekt-Transistor (MESFET), ein Metalloxidhalbleiter-Feldeffekt-Transistor (MOSFET), ein High Electron Mobility Transistor (HEMT), ein Ionen-Sensitiver Feldeffekt-Transistor (ISFET), ein Organischer Feldeffekttransistor (OFET) oder ein Insulated Gate Bipolar Transistor (IGBT) verwendet werden.

Beispielsweise kann es sich um einen Galiumnitrid-Transistor (GaN-Transistor) mit einem Halbleitersubstrat aus Siliziumcarbid (SiC) oder Silizium (Si) handeln.

Transistoren 2 weisen mindestens drei Kontakte 3, 4, 19 auf: Einen ersten Nutzstromkontakt 3, welcher je nach Art des Transistors 2 als Drain 3 oder Kollektor bezeichnet werden kann, einen zweiten Nutzstromkontakt 4, welcher je nach Art des Transistors 2 als Source 4 oder Emitter bezeichnet werden kann, und einen Steuerkontakt 19, welcher je nach Art des Transistors 2 auch als Gate 19 oder Basis bezeichnet werden kann.

Gemäß einer vorteilhaften Weiterbildung der Erfindung ist das Halbleitersubstrat 6 wenigstens eines der Leistungshalbleiterbauelemente 2 leitfähig ausgebildet. Das Halbleitersubstrat 6 kann insbesondere aus leitfähigem Siliziumcarbid oder leitfähigem Silizium bestehen.

Im Vergleich zu nichtleitfähigen Halbleitersubstraten 6 ergeben sich so Kostenvorteile.

Dabei kann das leitende Halbleitersubstrat 6 mittels einer isolierenden Struktur 32 von einem aktiven Bereich 33 des Leistungshalbleiterbauelements 2 elektrisch getrennt sein.

Fig. 8 zeigt eine schematische Darstellung eines zweiten Ausführungsbeispiels eines schaltbaren lateralen Leistungshalbleiterbauelements 2 für ein erfindungsgemäßes Leistungshalbleiterbauteil in einer teilweise geschnittenen Seitenansicht.

Das Halbleitersubstrat 6 besteht in diesem Ausführungsbeispiel aus einem nicht leitfähigen Material, bei dem es sich beispielsweise um nichtleitendes Siliziumcarbid handelt. Die isolierende Struktur 32 entfällt in diesem Ausführungsbeispiel.

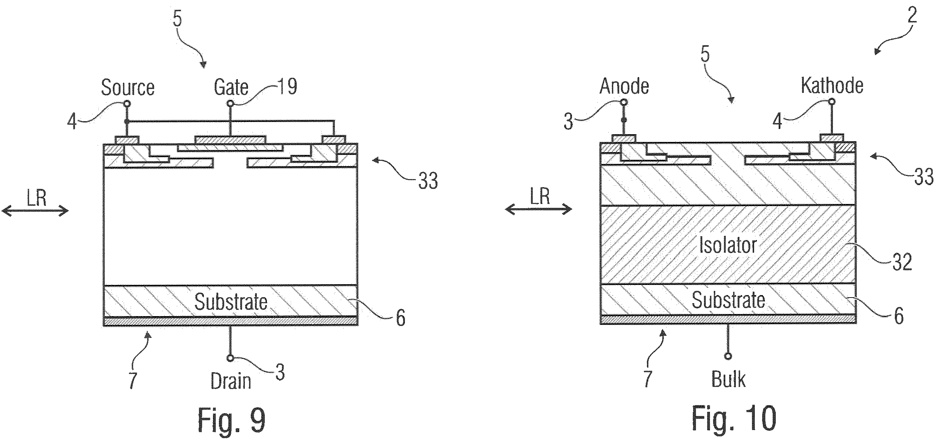

Fig. 9 zeigt zum Vergleich eine schematische Darstellung eines Ausführungsbeispiels eines schaltbaren vertikalen Leistungshalbleiterbauelements, welches für ein erfindungsgemäßes Leistungshalbleiterbauteil ungeeignet ist, in einer teilweise geschnittenen Seitenansicht.

Bei einem vertikalen Leistungshalbleiterbauelement sind der erste Nutzstromkontakt 3 und der zweite Nutzstromkontakt 4 an gegenüberliegenden Seiten angeordnet. Vertikale Leistungshalbleiterbauelemente sind für das erfindungsgemäße Leistungshalbleiterbauteil nicht geeignet.

Fig. 10 zeigt eine schematische Darstellung eines Ausführungsbeispiels eines nicht schaltbaren lateralen Leistungshalbleiterbauelements 2 für ein erfindungsgemäßes Leistungshalbleiterbauteil in einer teilweise geschnittenen Seitenansicht.

Bei dem nicht schaltbaren lateralen Leistungshalbleiterbauelement 2, kann es sich insbesondere um eine Diode 2 beliebiger Bauart handeln. Bei einer Diode 2 wird üblicherweise als erster Nutzstromkontakt 3 ein als Anode 3 bezeichneter Anschluss 3 und als zweiter Nutzstromkontakt 4 ein als Kathode4 bezeichneter Anschluss 4 verwendet. Ein Steuerkontakt ist bei einer Diode 2 im Regelfall nicht vorgesehen.

Die in den Fig. 7-10 gemachten Ausführungen gelten auch für die weiteren in dieser Anmeldung beschriebenen Leistungshalbleiterbauelemente 8, 37, 43.

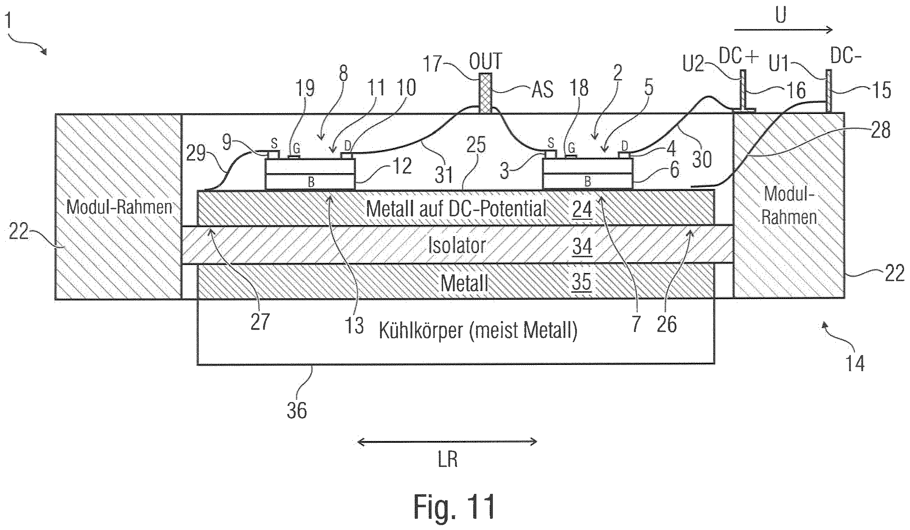

Fig. 11 zeigt eine schematische Darstellung eines dritten Ausführungsbeispiels eines erfindungsgemäßen Leistungshalbleiterbauteils 1 in einer teilweise geschnittenen Seitenansicht. Das dritte Ausführungsbeispiel beruht auf dem ersten Ausführungsbeispiel der Fig. 3 und 4, wobei im Folgenden lediglich die Unterschiede beschrieben sind.

Gemäß einer bevorzugten Weiterbildung der Erfindung weist das Trägersubstrat 23 eine elektrisch isolierende Schicht 34 auf, welche auf einer der nach außen weisenden Fläche 25 gegenüberliegenden Seite der leitenden Schicht 24 angeordnet ist.

Die elektrisch isolierende Schicht 34 kann als funktionale Isolation des Aufbaus vom Kühlkörper dienen. Ebenso kann die isolierende Schicht 34 als Sicherheitsisolierung dienen und beispielsweise vor gefährlichen Berührspannungen schützen. Als eine derartige isolierende Schicht 34 kann ein organischer Isolator verwendet werden.

Gemäß einer vorteilhaften Weiterbildung der Erfindung weist das Trägersubstrat 23 eine weitere leitende Schicht 35 auf, welche auf einer der nach außen weisenden Fläche 25 gegenüberliegenden Seite der isolierenden Schicht 35 angeordnet ist.

Die weitere leitende Schicht 35 ist bevorzugt gegenüber der isolierenden Schicht 34 elektrisch isoliert. Die weitere leitende Schicht 35 kann insbesondere aus Metall sein und die Wärmeabfuhr des Leistungshalbleiterbauteils verbessern.

Das Trägersubstrat 14 kann also eine leitende Schicht 24, eine elektrisch isolierende Schicht 34 und eine weitere leitende Schicht 35 aufweisen. Dabei kann das Trägersubstrat 14 eine DBC (Direct Bonded Copper) Struktur, auch DCB (Direct Copper Bonded), ein IMS-Substrat (Insulated metal substrate) oder ein AMB-Substrat (active metal braze) sein. Diese ermöglichen eine optimale Wärmeableitung und sind technisch günstig herstellbar. Die leitende Schicht kann aus Kupfer, Aluminium oder beliebigem anderem leitendem Material sein.

Gemäß einer bevorzugten Weiterbildung der Erfindung ist an einer der nach außen weisenden Fläche 25 gegenüberliegenden Fläche des Trägersubstrats 23 ein Kühlkörper 36 angeordnet.

Hierdurch kann die Kühlung der beiden Leistungshalbleiterbauelemente 2, 8 weiter verbessert werden.

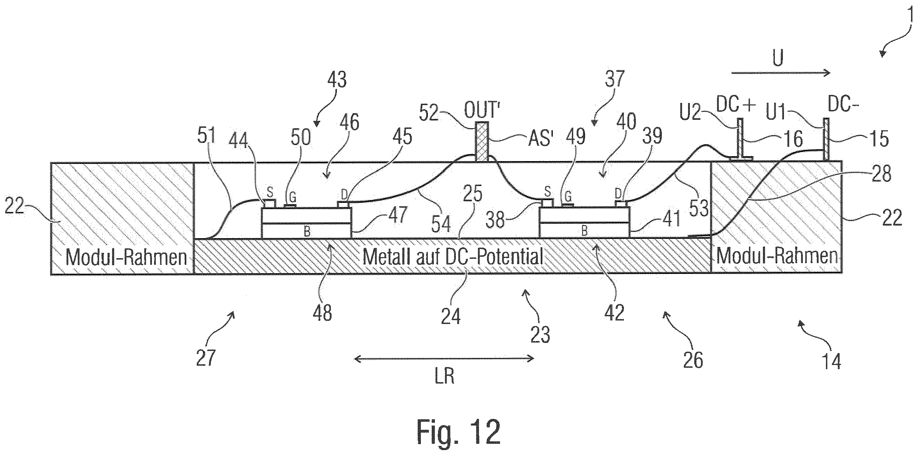

Fig. 12 zeigt eine schematische Darstellung eines vierten Ausführungsbeispiels eines erfindungsgemäßen Leistungshalbleiterbauteils 1 in einer teilweise geschnittenen Seitenansicht. Das vierte Ausführungsbeispiel beruht ebenfalls auf dem ersten Ausführungsbeispiel der Fig. 3 und 4, wobei im Folgenden lediglich die Unterschiede beschrieben sind.

Das Leistungshalbleiterbauteil 1 der Figur 12 umfasst zusätzlich:
ein drittes laterales Leistungshalbleiterbauelement 37, welches einen ersten Nutzstromkontakt 38 und einen zweiten Nutzstromkontakt 39 aufweist, welche beide an einer ersten Seite 40 des dritten Leistungshalbleiterbauelements 37 angeordnet sind, wobei das dritte Leistungshalbleiterbauelement 37 ein Halbleitersubstrat 41 aufweist, welches sich entlang einer der ersten Seite 40 gegenüberliegenden zweiten Seite 42 des dritten Leistungshalbleiterbauelements 37 erstreckt;
ein viertes laterales Leistungshalbleiterbauelement 43, welches einen ersten Nutzstromkontakt 44 und einen zweiten Nutzstromkontakt 45 aufweist, welche beide an einer ersten Seite 46 des vierten Leistungshalbleiterbauelements 43 angeordnet sind, wobei das vierte Leistungshalbleiterbauelement 43 ein Halbleitersubstrat 47 aufweist, welches sich entlang einer der ersten Seite 46 gegenüberliegenden zweiten Seite 48 des vierten Leistungshalbleiterbauelements 43 erstreckt;
wobei das dritte Leistungshalbleiterbauelement 37 und das vierte Leistungshalbleiterelement 43 als weitere Halbbrücke verschaltet sind;
wobei wenigstens eines von dem dritten Leistungshalbleiterbauelement 37 und dem vierten Leistungshalbleiterbauelement 43 als schaltbares Leistungshalbleiterbauelement 37, 43 ausgebildet ist, welches einen Steuerkontakt 49, 50 aufweist, welcher an der ersten Seite 40, 46 des jeweiligen Leistungshalbleiterbauelements 37, 43 angeordnet ist;
wobei das dritte Leistungshalbleiterbauelement 37 und das vierte Leistungshalbleiterelement 43 mit ihrer jeweiligen zweiten Seite 42, 48 an der nach außen weisenden Fläche 25 in der lateralen Richtung LR versetzt angeordnet sind;
wobei das dritte Leistungshalbleiterbauelement 37 an dem ersten endseitigen Abschnitt 26 der leitenden Schicht 24 angeordnet und das vierte Leistungshalbleiterbauelement 43 an dem zweiten endseitigen Abschnitt 27 der leitenden Schicht 24 angeordnet ist;
wobei der erste Nutzstromkontakt 44 des vierten Leistungshalbleiterbauelements 43 an dem zweiten endseitigen Abschnitt 27 der leitenden Schicht 24 mittels einer fünften elektrischen Verbindung 51 an die leitende Schicht 24 angeschlossen ist.

Auf diese Weise kann das Leistungshalbleiterbauteil 1 als schaltbare Vollbrücke verwendet werden, wobei die erste Halbbrücke das Zwischenpotential AS und die weitere Halbbrücke das Zwischenpotential AS' liefert, welches an einem weiteren Zwischenpotentialkontakt 52 abgegriffen werden kann.

Hinsichtlich der Figur 12 ist anzumerken, dass aus Vereinfachungsgründen das erste Leistungshalbleiterbauelement 2 und das zweite Leistungshalbleiterbauelements 8, welche die erste Halbbrücke bilden, weggelassen sind und, dass lediglich das dritte Leistungshalbleiterbauelement 37 und das vierte Leistungshalbleiterbauelement 43, welche die weitere Halbbrücke bilden, dargestellt sind.

Im Ausführungsbeispiel der Fig. 12 ist die erste Polarität der Außenspannung U vorgesehen, bei der das zweite Potenzial U2 der Außenspannung U höher ist als das erste Potenzial U1 der Außenspannung. Bei der ersten Polarität kann der erste Nutzstromkontakt 44 des vierten Leistungshalbleiterbauelements 43 eine Source eines Feldeffekttransistors 43 sein. Die leitende Schicht 24 nimmt das erste Potenzial U1 an, welches in diesem Fall das kleinere Potenzial ist, so dass die leitende Schicht 24 die Funktion eines Rückleiters des Stroms annimmt.

In einem nicht gezeigten Ausführungsbeispiel ist die zweite Polarität der Außenspannung U vorgesehen, bei der das zweite Potenzial U2 der Außenspannung U tiefer ist als das erste Potenzial U1 der Außenspannung U. Bei der zweiten Polarität kann der erste Nutzstromkontakt 44 des vierten Leistungshalbleiterbauelements 43 ein Drain eines Feldeffekttransistors 43 sein. Die leitende Schicht 24 nimmt das erste Potenzial U1 an, welches in diesem Fall das höhere Potenzial ist, so dass die leitende Schicht 24 die Funktion eines Hinleiters des Stroms annimmt.

Gemäß einer bevorzugten Weiterbildung der Erfindung ist mittels einer sechsten elektrischen Verbindung 53 der zweite Kontakt 16 mit dem zweiten Nutzstromkontakt 39 des dritten Leistungshalbleiterbauelements 37 verbunden.

Wenn, wie in Figur 12 dargestellt, die erste Polarität der Außenspannung U vorgesehen ist, kann der zweite Nutzstromkontakt 39 des dritten Leistungshalbleiterbauelements 37 ein Drain eines Feldeffekttransistors 37 sein.

Sofern jedoch die zweite Polarität der Außenspannung U vorgesehen ist, kann der zweite Nutzstromkontakt 39 des dritten Leistungshalbleiterbauelements 37 eine Source eines Feldeffekttransistors 37 sein.

Gemäß einer weiteren vorteilhaften Weiterbildung der Erfindung ist mittels einer siebten elektrischen Verbindung 54 der erste Nutzstromkontakt 38 des dritten Leistungshalbleiterbauelements 37 mit dem zweiten Nutzstromkontakt 45 des vierten Leistungshalbleiterbauelements 43 verbunden.

Wenn, wie in Figur 12 dargestellt, die erste Polarität der Außenspannung U vorgesehen ist, kann der erste Nutzstromkontakt 38 des dritten Leistungshalbleiterbauelements 37 eine Source eines Feldeffekttransistors 37 und der zweite Nutzstromkontakt 45 des vierten Leistungshalbleiterbauelements 43 ein Drain eines Feldeffekttransistors 43 sein.

Sofern jedoch die zweite Polarität der Außenspannung U vorgesehen ist, kann der erste Nutzstromkontakt 38 des dritten Leistungshalbleiterbauelements 37 ein Drain eines Feldeffekttransistors 37 und der zweite Nutzstromkontakt 45 des vierten Leistungshalbleiterbauelements 43 eine Source eines Feldeffekttransistors 43 sein.

Gemäß einer bevorzugten Weiterbildung der Erfindung sind eine oder mehrere der besagten elektrischen Verbindungen 28, 29, 30, 31, 52, 53, 54 als drahtgebondete Verbindung ausgebildet.

In den Ausführungsbeispielen der Figuren 3, 5, 11 und 12 sind sämtliche der besagten elektrischen Verbindungen 28, 29, 30, 31, 52, 53, 54, soweit vorhanden, als drahtgebundene der Verbindung 28, 29, 30, 31, 52, 53, 54 ausgebildet.

Drahtgebondete Verbindungen zeichnen sich insbesondere durch ihre leichte Herstellbarkeit aus.

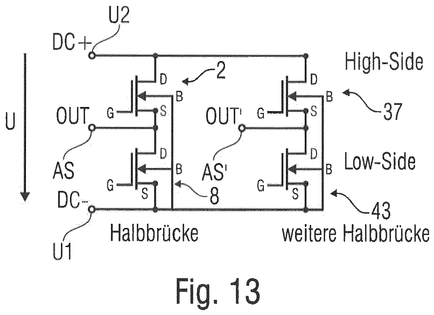

Fig. 13 zeigt einen Schaltplan des Leistungshalbleiterbauteils 1 der Fig. 12.

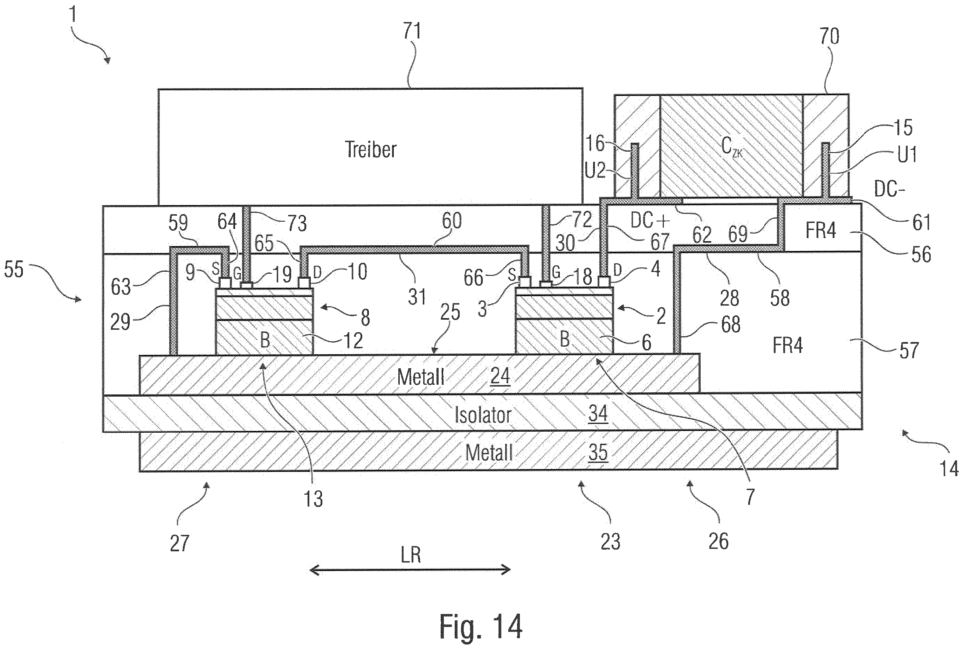

Fig. 14 zeigt eine schematische Darstellung eines fünften Ausführungsbeispiels eines erfindungsgemäßen Leistungshalbleiterbauteils 1 in einer teilweise geschnittenen Seitenansicht.

Gemäß einer bevorzugten Weiterbildung der Erfindung umfasst die Trägeranordnung 14 eine Leiterplattenanordnung 55, in welche wenigstens eines der besagten Leistungshalbleiterbauelemente 2, 8, 37, 43 eingebettet ist, wobei eine oder mehrere der besagten elektrischen Verbindungen 28, 29, 30, 31, 52, 53, 54 eine Leiterbahn 58-62 der Leiterplattenanordnung 55 und/oder eine Durchkontaktierung 63-69 der Leiterplattenanordnung 55 umfasst.

Unter einem in eine Leiterplattenanordnung 55 eingebetteten Leistungshalbleiterbauelement 2, 8, 37, 43 wird ein solches Leistungshalbleiterbauelement 2, 8, 37, 43 verstanden, welches zu einem überwiegenden Teil, wenigstens jedoch zu einem wesentlichen Teil, von der Leiterplattenanordnung 55 umhüllt ist. Unter einer Leiterplattenanordnung 55 wird eine solche Anordnung verstanden, welche wenigstens eine flache elektrisch isolierende Schicht 56, 57 umfasst, an der Leiterbahnen 58-62 ausgebildet sind.

Unter einer Durchkontaktierung 63-69 wird eine elektrische Verbindung verstanden, welche wenigstens teilweise durch eine der isolierenden Schichten 56, 57 hindurch wirksam ist.

Im Ausführungsbeispiel der Fig. 14 umfasst die Leiterplattenanordnung 55 eine erste Isolierschicht 56 und eine zweite Isolierschicht 57, welche beispielsweise aus dem Werkstoff FR4 bestehen können. FR-4 oder auch FR4 bezeichnet eine Klasse von schwer entflammbaren und flammenhemmenden Verbundwerkstoffen bestehend aus Epoxidharz und Glasfasergewebe.

Wie beispielhaft gezeigt, kann die erste elektrische Verbindung 28 aus den Leiterbahnen 58 und 61 sowie den Durchkontaktierungen 68 und 69 bestehen. Ebenso kann die zweite elektrische Verbindung 29 aus der Leiterbahnen 59 sowie den Durchkontaktierungen 63 und 64 bestehen. In gleicher Weise kann die dritte elektrische Verbindung 30 aus der Leiterbahnen 62 und aus der Durchkontaktierungen 67 bestehen. Weiterhin kann die vierte elektrisehe Verbindung 31 aus der Leiterbahnen 60 sowie aus den Durchkontaktierungen 65 und 66 bestehen.

Die Einbettung der besagten Leistungshalbleiterbauelemente 2, 8, 37, 43 erlaubt einen stabilen und kompakten Aufbau, was aufgrund von kurzen Leitungslängen auch zu elektrischen Vorteilen, nämlich zu geringen ohmschen Verlusten und zu geringen unerwünschten induktiven und kapazitiven Belägen, führen kann.

Gemäß einer bevorzugten Weiterbildung der Erfindung sind der erste Kontakt 15 und der zweite Kontakt 16 in der lateralen Richtung LR gesehen an einem selben endseitigen Bereich des Leistungshalbleiterbauteils 1 angeordnet.

Unter einem endseitigen Bereich des Leistungshalbleiterbauteils 1 kann dabei in einem weiteren Sinn ein Bereich verstanden werden, der sich in der lateralen Richtung LR gesehen von einem Ende des Leistungshalbleiterbauteils 1 bis zur Mitte des Leistungshalbleiterbauteils 1 erstreckt. In einem engeren Sinn kann unter dem endseitigen Bereich ein Bereich verstanden werden, der sich von dem jeweiligen Ende des Leistungshalbleiterbauteils 1 in der lateralen Richtung LR gesehen über ein Drittel der Gesamtlänge des Leistungshalbleiterbauteils 1 erstreckt.

Die Vorteile einer derartigen Anordnung des ersten Kontakts 15 und des zweiten Kontakts 16 liegen insbesondere darin, dass das Anschließen der Kontakte 15 und 16 erleichtert wird, und das auf dem jeweils anderen endseitigen Bereich über den Leistungshalbleiterbauelementen 2, 8 ein freier Raum zur Anordnung von anderen Bauelementen geschaffen wird.

Gemäß einer bevorzugten Weiterbildung der Erfindung ist auf einem dem Trägersubstrat 23 abgewandten Seite des Leistungshalbleiterbauteils 1 an dem endseitigen Bereich des Leistungshalbleiterbauteils 1 ein Kondensator 70 angeordnet.

Bei dem Kondensator 70 kann es sich insbesondere um einen Zwischenkreiskondensator 70 eines Wechselrichters, eines Gleichspannungswandlers oder eines Frequenzumrichters handeln.

Der Kondensator 70 kann dabei mit kurzen Leitungslängen oder sogar direkt mit dem ersten Kontakt 15 und dem zweiten Kontakt 16 verbunden werden

Nach einer besonders bevorzugten Weiterbildung der Erfindung ist auf der dem Trägersubstrat 23 abgewandten Seite des Leistungshalbleiterbauteils 1 in der lateralen Richtung LR gesehen in einem Bereich des ersten Leistungshalbleiterbauelements 2 und des zweiten Leistungshalbleiterbauelements 8 wenigstens ein Teil eines Treibers 71 angeordnet, der zum Schalten des wenigstens einen schaltbaren Leistungshalbleiterbauelements 2, 8, 37, 43 der Leistungshalbleiterbauelemente 2, 8, 37, 43 ausgebildet ist.

Im Ausführungsbeispiel der Figur 14 ist der Treiber 71 über eine Durchkontaktierung 72 mit dem Steuerkontakt 18 des ersten Leistungshalbleiterbauelements 2 und über eine Durchkontaktierung 73 mit dem Steuerkontakt 19 des zweiten Leistungshalbleiterbauelements 8 verbunden. Bei der Durchkontaktierung 72 und bei der Durchkontaktierung 73 könnte es sich jedoch auch um andere elektrische Verbindungen handeln.

Die erfindungsgemäße Anordnung des Treibers 71 ermöglicht geringe Leitungslängen beziehungsweise geringe Impedanz und insbesondere geringe Induktivität der Zuleitung zum Anschließen des Treibers 71 an die Leistungshalbleiterbauelemente 2, 8, 37, 43.

### Bezugszeichen:

- 1: Leistungshalbleiterbauteil
- 2: erstes laterales Leistungshalbleiterbauelement
- 3: erster Nutzstromkontakt
- 4: zweiter Nutzstromkontakt
- 5: ersten Seite
- 6: Halbleitersubstrat
- 7: zweiten Seite
- 8: zweites laterales Leistungshalbleiterbauelement
- 9: erster Nutzstromkontakt
- 10: zweiter Nutzstromkontakt
- 11: ersten Seite
- 12: Halbleitersubstrat
- 13: zweiten Seite
- 14: Trägeranordnung
- 15: erster Kontakt
- 16: zweiter Kontakt
- 17: Zwischenpotentialkontakt
- 18: Steuerkontakt
- 19: Steuerkontakt
- 20: Metallträger
- 21: Metallträger
- 22: Rahmen
- 23: Trägersubstrat
- 24: leitende Schicht
- 25: nach außen weisenden Fläche
- 26: erste endseitiger Abschnitt
- 27: zweiter endseitiger Abschnitt
- 28: erste elektrische Verbindung
- 29: zweite elektrische Verbindung
- 30: dritte elektrische Verbindung
- 31: vierte elektrische Verbindung
- 32: isolierende Struktur
- 33: aktiver Bereich
- 34: elektrisch isolierende Schicht
- 35: weitere leitende Schicht
- 36: Kühlkörper
- 37: drittes laterales Leistungshalbleiterelement
- 38: erster Nutzstromkontakt
- 39: zweiter Nutzstromkontakt
- 40: erste Seite
- 41: Halbleitersubstrat
- 42: zweiten Seite
- 43: viertes laterales Leistungshalbleiterbauelement
- 44: erster Nutzstromkontakt
- 45: zweiter Nutzstromkontakt
- 46: erste Seite
- 47: Halbleitersubstrat
- 48: zweiten Seite
- 49: Steuerkontakt
- 50: Steuerkontakt
- 51: fünfte elektrische Verbindung
- 52: weiterer Zwischenpotentialkontakt
- 53: sechste elektrische Verbindung
- 54: siebte elektrische Verbindung
- 55: Leiterplattenanordnung
- 56: erste Isolierschicht
- 57: zweite Isolierschicht
- 58: Leiterbahn
- 59: Leiterbahn
- 60: Leiterbahn
- 61: Leiterbahn
- 62: Leiterbahn
- 63: Durchkontaktierung
- 64: Durchkontaktierung
- 65: Durchkontaktierung
- 66: Durchkontaktierung
- 67: Durchkontaktierung
- 68: Durchkontaktierung
- 69: Durchkontaktierung
- 70: Kondensator
- 71: Treiber
- 72: Durchkontaktierung
- 73: Durchkontaktierung

- U1: erstes Potential
- U2: zweites Potential
- U: Außenspannung
- AS: Zwischenpotential
- LR: laterale Richtung
- AS': weiteres Zwischenpotential

## Patentansprüche

1. Leistungshalbleiterbauteil umfassend:
ein erstes laterales Leistungshalbleiterbauelement (2), welches einen ersten Nutzstromkontakt (3) und einen zweiten Nutzstromkontakt (4) aufweist, welche beide an einer ersten Seite (5) des ersten Leistungshalbleiterbauelements (2) angeordnet sind, wobei das erste Leistungshalbleiterbauelement (2) ein Halbleitersubstrat (6) aufweist, welches sich entlang einer der ersten Seite (5) gegenüberliegenden zweiten Seite (7) des ersten Leistungshalbleiterbauelements (2) erstreckt;
ein zweites laterales Leistungshalbleiterbauelement (8), welches einen ersten Nutzstromkontakt (9) und einen zweiten Nutzstromkontakt (10) aufweist, welche beide an einer ersten Seite (11) des zweiten Leistungshalbleiterbauelements (8) angeordnet sind, wobei das zweite Leistungshalbleiterbauelement (8) ein Halbleitersubstrat (12) aufweist, welches sich entlang einer der ersten Seite (11) gegenüberliegenden zweiten Seite (13) des zweiten Leistungshalbleiterbauelements (8) erstreckt;
eine Trägeranordnung (14), welche ein Trägersubstrat (23) aufweist, welches eine leitende Schicht (24) mit einer nach außen weisenden Fläche (25) umfasst;
ein erster an der Trägeranordnung (14) angeordneter Kontakt (15) zum Anschließen eines ersten Potentials (U1) einer Außenspannung (U) an eine externe Schaltung; und
ein zweiter an der Trägeranordnung (14) angeordneter Kontakt (16) zum Anschließen eines zweiten Potentials (U2) der Außenspannung (U) an die externe Schaltung;
wobei die besagten Leistungshalbleiterbauelemente (2, 8) als Halbbrücke verschaltet sind;
wobei wenigstens eines der besagten Leistungshalbleiterbauelemente (2, 8) als schaltbares Leistungshalbleiterbauelement (2, 8) ausgebildet ist, welches einen Steuerkontakt (18, 19) aufweist, welcher an der ersten Seite (5, 11) des jeweiligen Leistungshalbleiterbauelements (2, 8) angeordnet ist;
wobei das erste Leistungshalbleiterbauelement (2) und das zweite Leistungshalbleiterelement (8) mit ihrer jeweiligen zweiten Seite (7, 13) an der nach außen weisenden Fläche (25) in einer lateralen Richtung (LR) versetzt angeordnet sind;
wobei das erste Leistungshalbleiterbauelement (2) an einem in der lateralen Richtung (LR) gesehen ersten endseitigen Abschnitt (26) der leitenden Schicht (24) angeordnet und das zweite Leistungshalbleiterbauelement (8) an einem dem ersten endseitigen Abschnitt (26) in der lateralen Richtung (LR) gesehen gegenüberliegenden zweiten endseitigen Abschnitt (27) der leitenden Schicht (24) angeordnet ist;
wobei der erste Kontakt (15) an dem ersten endseitigen Abschnitt (26) der leitenden Schicht (24) mittels einer ersten elektrischen Verbindung (28) an die leitende Schicht (24) angeschlossen ist;
wobei der erste Nutzstromkontakt (9) des zweiten Leistungshalbleiterbauelements (8) an dem zweiten endseitigen Abschnitt (27) der leitenden Schicht (24) mittels einer zweiten elektrischen Verbindung (29) an die leitende Schicht (24) angeschlossen ist.

2. Leistungshalbleiterbauteil nach vorstehendem Anspruch, wobei mittels einer dritten elektrischen Verbindung (30) der zweite Kontakt (16) mit dem zweiten Nutzstromkontakt (4) des ersten Leistungshalbleiterbauelements (2) verbunden ist.

3. Leistungshalbleiterbauteil nach einem der vorstehenden Ansprüche, wobei mittels einer vierten elektrischen Verbindung (31) der erste Nutzstromkontakt (3) des ersten Leistungshalbleiterbauelements (2) mit dem zweiten Nutzstromkontakt (10) des zweiten Leistungshalbleiterbauelements (8) verbunden ist.

4. Leistungshalbleiterbauteil nach einem der vorstehenden Ansprüche, wobei das Trägersubstrat (23) eine elektrisch isolierende Schicht (34) aufweist, welche auf einer der nach außen weisenden Fläche (25) gegenüberliegenden Seite der leitenden Schicht (24) angeordnet ist.

5. Leistungshalbleiterbauteil nach vorstehendem Anspruch, wobei das Trägersubstrat (23) eine weitere leitende Schicht (35) aufweist, welche auf einer der nach außen weisenden Fläche (25) gegenüberliegenden Seite der isolierenden Schicht (35) angeordnet ist.

6. Leistungshalbleiterbauteil nach einem der vorstehenden Ansprüche, wobei an einer der nach außen weisenden Fläche (25) gegenüberliegenden Fläche des Trägersubstrats (23) ein Kühlkörper (36) angeordnet ist.

7. Leistungshalbleiterbauteil nach einem der vorstehenden Ansprüche, zusätzlich umfassend:
ein drittes laterales Leistungshalbleiterbauelement (37), welches einen ersten Nutzstromkontakt (38) und einen zweiten Nutzstromkontakt (39) aufweist, welche beide an einer ersten Seite (40) des dritten Leistungshalbleiterbauelements (37) angeordnet sind, wobei das dritte Leistungshalbleiterbauelement (37) ein Halbleitersubstrat (41) aufweist, welches sich entlang einer der ersten Seite (40) gegenüberliegenden zweiten Seite (42) des dritten Leistungshalbleiterbauelements (37) erstreckt; und
ein viertes laterales Leistungshalbleiterbauelement (43), welches einen ersten Nutzstromkontakt (44) und einen zweiten Nutzstromkontakt (45) aufweist, welche beide an einer ersten Seite (46) des vierten Leistungshalbleiterbauelements (43) angeordnet sind, wobei das vierte Leistungshalbleiterbauelement (43) ein Halbleitersubstrat (47) aufweist, welches sich entlang einer der ersten Seite (46) gegenüberliegenden zweiten Seite (48) des vierten Leistungshalbleiterbauelements (43) erstreckt;
wobei das dritte Leistungshalbleiterbauelement (37) und das vierte Leistungshalbleiterelement (43) als weitere Halbbrücke verschaltet sind;
wobei wenigstens eines von dem dritten Leistungshalbleiterbauelement (37) und dem vierten Leistungshalbleiterbauelement (43) als schaltbares Leistungshalbleiterbauelement (37, 43) ausgebildet ist, welches einen Steuerkontakt (49, 50) aufweist, welcher an der ersten Seite (40, 46) des jeweiligen Leistungshalbleiterbauelements (37, 43) angeordnet ist;
wobei das dritte Leistungshalbleiterbauelement (37) und das vierte Leistungshalbleiterelement (43) mit ihrer jeweiligen zweiten Seite (42, 48) an der nach außen weisenden Fläche (25) in der lateralen Richtung (LR) versetzt angeordnet sind;
wobei das dritte Leistungshalbleiterbauelement (37) an dem ersten endseitigen Abschnitt (26) der leitenden Schicht (24) angeordnet und das vierte Leistungshalbleiterbauelement (43) an dem zweiten endseitigen Abschnitt (27) der leitenden Schicht (24) angeordnet ist;
wobei der erste Nutzstromkontakt (44) des vierten Leistungshalbleiterbauelements (43) an dem zweiten endseitigen Abschnitt (27) der leitenden Schicht (24) mittels einer fünften elektrischen Verbindung (51) an die leitende Schicht (24) angeschlossen ist.

8. Leistungshalbleiterbauteil nach vorstehendem Anspruch, wobei mittels einer sechsten elektrischen Verbindung (53) der zweite Kontakt (16) mit dem zweiten Nutzstromkontakt (39) des dritten Leistungshalbleiterbauelements (37) verbunden ist.

9. Leistungshalbleiterbauteil nach Anspruch 7 oder 8, wobei mittels einer siebten elektrischen Verbindung (54) der erste Nutzstromkontakt (38) des dritten Leistungshalbleiterbauelements (37) mit dem zweiten Nutzstromkontakt (45) des vierten Leistungshalbleiterbauelements (43) verbunden ist.

10. Leistungshalbleiterbauteil nach einem der vorstehenden Ansprüche, wobei das Halbleitersubstrat (6, 12, 41, 47) wenigstens eines der Leistungshalbleiterbauelemente (2, 8, 37, 43) leitfähig ausgebildet ist.

11. Leistungshalbleiterbauteil nach, wobei eine oder mehrere der besagten elektrischen Verbindungen (28, 29, 30, 31, 51, 53, 54) als drahtgebondete Verbindung ausgebildet sind.

12. Leistungshalbleiterbauteil nach einem der vorstehenden Ansprüche, wobei die Trägeranordnung (14) eine Leiterplattenanordnung (55) umfasst, in welche wenigstens eines der besagten Leistungshalbleiterbauelemente (2, 8, 37, 43) eingebettet ist, wobei eine oder mehrere der besagten elektrischen Verbindungen (28, 29, 30, 31, 51, 53, 54) eine Leiterbahn (58-62) der Leiterplattenanordnung (55) und/oder eine Durchkontaktierung (63-69) der Leiterplattenanordnung (55) umfasst.

13. Leistungshalbleiterbauteil nach einem der vorstehenden Ansprüche, wobei der erste Kontakt (15) und der zweite Kontakt (16) in der lateralen Richtung (LR) gesehen an einem selben endseitigen Bereich des Leistungshalbleiterbauteils (1) angeordnet sind.

14. Leistungshalbleiterbauteil nach einem der vorstehenden Ansprüche, wobei auf einem dem Trägersubstrat (23) abgewandten Seite des Leistungshalbleiterbauteils (1) an dem endseitigen Bereich des Leistungshalbleiterbauteils (1) ein Kondensator (70) angeordnet ist.

15. Leistungshalbleiterbauteil nach einem der vorstehenden Ansprüche, wobei auf der dem Trägersubstrat (23) abgewandten Seite des Leistungshalbleiterbauteils (1) in der lateralen Richtung (LR) gesehen in einem Bereich des ersten Leistungshalbleiterbauelements (2) und des zweiten Leistungshalbleiterbauelements (8) wenigstens ein Teil eines Treibers (71) angeordnet ist, der zum Schalten des wenigstens einen schaltbaren Leistungshalbleiterbauelements (2, 8, 37, 43) der Leistungshalbleiterbauelemente (2, 8, 37, 43) ausgebildet ist.

16. Verfahren zum Herstellen eines Leistungshalbleiterbauteils (1) umfassend die Schritte:
Bereitstellen eines ersten lateralen Leistungshalbleiterbauelements (2), welches einen ersten Nutzstromkontakt (3) und einen zweiten Nutzstromkontakt (4) aufweist, welche beide an einer ersten Seite (5) des ersten Leistungshalbleiterbauelements (2) angeordnet sind, wobei das erste Leistungshalbleiterbauelement (2) ein Halbleitersubstrat (6) aufweist, welches sich entlang einer der ersten Seite (5) gegenüberliegenden zweiten Seite (7) des ersten Leistungshalbleiterbauelements (2) erstreckt;
Bereitstellen eines zweiten lateralen Leistungshalbleiterbauelements (8), welches einen ersten Nutzstromkontakt (9) und einen zweiten Nutzstromkontakt (10) aufweist, welche beide an einer ersten Seite (11) des zweiten Leistungshalbleiterbauelements (8) angeordnet sind, wobei das zweite Leistungshalbleiterbauelement (8) ein Halbleitersubstrat (12) aufweist, welches sich entlang einer der ersten Seite (11) gegenüberliegenden zweiten Seite (13) des zweiten Leistungshalbleiterbauelements (8) erstreckt;
Bereitstellen einer Trägeranordnung (14), welche ein Trägersubstrat (23) aufweist, welches eine leitende Schicht (24) mit einer nach außen weisenden Fläche (25) umfasst;
Anordnen eines ersten Kontakts (15) an der Trägeranordnung (14), welcher zum Anschließen eines ersten Potentials (U1) einer Außenspannung (U) an eine externe Schaltung vorgesehen ist; und
Anordnen eines zweiten Kontakts (16) an der Trägeranordnung (14), welcher zum Anschließen eines zweiten Potentials (U2) der Außenspannung (U) an die externe Schaltung vorgesehen ist;
wobei die besagten Leistungshalbleiterbauelemente (2, 8) als Halbbrücke verschaltet werden;
wobei wenigstens eines der besagten Leistungshalbleiterbauelemente (2, 8) als schaltbares Leistungshalbleiterbauelement (2, 8) ausgebildet ist, welches einen Steuerkontakt (18, 19) aufweist, welcher an der ersten Seite (5, 11) des jeweiligen Leistungshalbleiterbauelements (2, 8) angeordnet ist;
wobei das erste Leistungshalbleiterbauelement (2) und das zweite Leistungshalbleiterelement (8) mit ihrer jeweiligen zweiten Seite (7, 13) an der nach außen weisenden Fläche (25) in einer lateralen Richtung (LR) versetzt angeordnet werden;
wobei das erste Leistungshalbleiterbauelement (2) an einem in der lateralen Richtung (LR) gesehen ersten endseitigen Abschnitt (26) der leitenden Schicht (24) angeordnet und das zweite Leistungshalbleiterbauelement (8) an einem dem ersten endseitigen Abschnitt (26) in der lateralen Richtung (LR) gesehen gegenüberliegenden zweiten endseitigen Abschnitt (27) der leitenden Schicht (24) angeordnet wird;
wobei der erste Kontakt (15) an dem ersten endseitigen Abschnitt (26) der leitenden Schicht (24) mittels einer ersten elektrischen Verbindung (28) an die leitende Schicht (24) angeschlossen wird;
wobei der erste Nutzstromkontakt (9) des zweiten Leistungshalbleiterbauelements (8) an dem zweiten endseitigen Abschnitt (27) der leitenden Schicht (24) mittels einer zweiten elektrischen Verbindung (29) an die leitende Schicht (24) angeschlossen wird.
